# EUROPÄISCHE PATENTSCHRIFT

(11) **EP 3 140 097 B1**
(45) Veröffentlichungstag und Bekanntmachung des Hinweises auf die Patenterteilung: **04.09.2019**
(21) Anmeldenummer: 15720099.9
(22) Anmeldetag: 07.05.2015
(51) Int. Cl.: B29C 45/14, H01L 33/00

(54) **MEHRSCHICHTKÖRPER UND VERFAHREN ZU DESSEN HERSTELLUNG**
MULTILAYER BODY AND METHOD FOR PRODUCING SAME
CORPS MULTICOUCHE ET PROCÉDÉ DE FABRICATION DE CELUI-CI

(30) Priorität: 09.05.2014 DE 102014106585
(43) Veröffentlichungstag der Anmeldung: 15.03.2017
(73) Patentinhaber: Leonhard Kurz Stiftung & Co. KG, 90763 Fürth (DE); PolyIC GmbH & Co. KG, 90763 Fürth (DE)
(72) Erfinder: LUDWIG, Klaus, 91058 Erlangen (DE); SCHULZ, Christian, 90768 Fürth (DE); STAHL, Rainer, 90449 Nürnberg (DE)
(74) Vertreter: Louis Pöhlau Lohrentz
(86) Internationale Anmeldenummer: PCT/EP2015/060029
(87) Internationale Veröffentlichungsnummer: WO 2015/169890

(56) Entgegenhaltungen:
- WO-A2-2011/006634
- DE-A1- 19 717 740
- US-A1- 2008 180 957
- Carl Hanser Verlag ET AL: "Selbstleuchtende Seiten-begrenzung für Lkw", , 30. Juni 2010 (2010-06-30), XP055204300, Gefunden im Internet: URL:https://www.kunststoffe.de/_storage/as set/538240/storage/master/file/13985838/do wnload/Selbstleuchtende Seitenbegrenzung für Lkw.pdf [gefunden am 2015-07-23]

## Beschreibung

Die Erfindung betrifft ein Verfahren zum Herstellen eines Mehrschichtkörpers sowie einen derart hergestellten Mehrschichtkörper.

Bei der Herstellung von Kunststoffbauteilen ist in zunehmendem Maße neben einer Dekoration auch die Integration elektronischer Funktionen gefordert. So werden schon seit langem Kunststoffteile mit Beleuchtungselementen versehen, um den Nutzer auf einen bestimmten Gerätezustand hinzuweisen (z.B. Schaltelemente in einem Kraftwagen, Bedienblenden von Haushaltsgeräten).

Üblicherweise muss dazu das bereits dekorierte Kunststoffteil in einem zusätzlichen Fertigungsschritt mit einer konventionellen Platine verbunden werden, die Leuchtelemente, beispielsweise Leuchtdioden, und/oder andere elektronische Bauteile trägt. Oftmals müssen in weiteren Fertigungsschritten zusätzliche Schichten zwischen Kunststoffblende und dem Leuchtelement eingebaut werden, die zum Beispiel eine Punktlichtquelle wie eine Leuchtdiode in einen Flächenstrahler verwandeln (Diffusorfolien in Form einer zusätzlichen Schicht) oder das Licht zu verschiedenen Positionen leiten (Lichtleiter in Form einer zusätzlichen Schicht). Die LED-Platine muss zudem mittels Steckverbindungen an eine Hauptplatine oder einen Controller des Gerätes angeschlossen werden.

Die US 2008/0180957 A1 offenbart beispielsweise eine LED-Platine, welche mit einem bereits dekorierten Spritzgussteil verbunden wird.

Die WO 2011/006634 A2 offenbart ein Verfahren zur Herstellung eines Mehrschichtkörpers mit einer Trägerlage und einer auf und/oder in der Trägerlage ausgebildeten ein oder mehrschichtigen Dekorlage, sowie einen danach erhältlichen Mehrschichtkörper.

Das Dokument XP055204300 offenbart eine selbstleuchtende Seitenbegrenzung für LKW.

Die DE 197 17 740 A1 offenbart Kunststoff-Formkörper mit grafisch gestalteter Oberfläche und integrierten Elektrolumineszenzelementen.

Insgesamt ist daher die Herstellung solcher dekorierter Kunststoffbauteile mit integrierten elektronischen Funktionen aufwändig und teuer.

Aufgabe der vorliegenden Erfindung ist es somit, ein besonders einfaches und kostengünstiges Verfahren zum Herstellen eines Mehrschichtkörpers mit integriertem Dekor und elektronischen Funktionen, sowie einen solchen Mehrschichtkörper anzugeben.

Erfindungsgemäß wird diese Aufgabe mit dem Gegenstand der Ansprüche 1 und 12 gelöst.

Unter einer "Lage" soll dabei ein vorzugsweise im Wesentlichen flächiges Gebilde verstanden werden, welches selbst wiederum aus mehreren Schichten bestehen kann. Es kann sich dabei beispielsweise um eine Folie oder eine Platine handeln. Alternativ sind jedoch auch komplexere dreidimensionale Geometrien möglich, insbesondere für die im Spritzguss hergestellte Kunststofflage.

Eine solche Lage muss dabei nicht notwendigerweise ein eigenständiges Bauteil darstellen, beispielsweise kann eine Dekorlage auch durch Drucken auf einen Untergrund gebildet werden.

Die Verbindung von Dekorlage, Trägerlage und Kunststofflage kann somit in einem einzigen Arbeitsschritt erfolgen. Eine nachträgliche Montage elektronischer Bauelemente ist nicht notwendig, so dass die Herstellung eines Mehrschichtkörpers mit integriertem Dekor und integrierter Beleuchtung auf diese Weise besonders einfach und kostengünstig ist. Ferner wird so ein besonders stabiler und haltbarer Mehrschichtkörper geschaffen, dessen Schichten prozesssicher in einer definierten Lagebeziehung angeordnet werden können.

Bezüglich der relativen Anordnung der Lagen bestehen mehrere Möglichkeiten:
Zunächst ist es möglich, dass die Dekorlage auf die Trägerlage aufgebracht wird. Dies kann vor dem Spritzgießen der Kunststofflage erfolgen, so dass Dekorlage und Trägerlage gemeinsam hinter- oder umspritzt werden. Es ist jedoch auch möglich, die Dekorlage erst nach dem Spritzgießen anzubringen, beispielsweise durch Laminieren einer Folie oder durch Drucken auf den Verbund aus Träger- und Kunststofflage. Träger- und Dekorlage können auch gemeinsam in das Spritzgusswerkzeug eingelegt werden, so dass sie in direktem Kontakt stehen und während des Spritzgießens verbunden werden. Dazu kann eine der Lagen beispielsweise mit einem wärmeaktivierbaren Klebstoff versehen werden, der unter den Druck- und Temperaturbedingungen des Spritzgussvorgangs aktiviert wird.

Es ist dabei möglich, dass die Dekorlage auf die dem zumindest einen Leuchtmittel abgewandte Seite der Trägerlage aufgebracht wird. Das Licht des zumindest einen Leuchtmittels tritt dann sowohl durch die Trägerlage als auch durch die Dekorlage. Die Trägerlage selbst kann damit ebenfalls als farbgebende Schicht, als Diffusor oder als ähnliches optisches Element dienen.

Alternativ kann die Dekorlage auch auf die dem zumindest einen Leuchtmittel zugewandte Seite der Trägerlage, insbesondere zwischen dem Leuchtmittel und der Trägerlage, aufgebracht werden. Hierdurch wird ein kürzerer Strahlengang für das austretende Licht verwirklicht, so dass geringere Absorptionsverluste auftreten.

Hierbei kann die Trägerlage auch ablösbar gestaltet werden, so dass sie nach dem Hinterspritzen entfernt werden kann. Es verbleiben dann lediglich die Leuchtmittel und die Dekorlage, sowie gegebenenfalls weitere funktionale Elemente wie Leiterbahnen oder dergleichen an der Kunststofflage.

Es ist dabei zweckmäßig, wenn die Dekorlage und die Trägerlage in einer Formhälfte des Spritzgusswerkzeugs fixiert werden, insbesondere durch mechanische Klemmmittel und/oder Vakuum, und einseitig hinterspritzt werden.Das Hinterspritzen kann dabei auf Seite der Dekorlage oder auch der Trägerlage erfolgen. Dabei ist es vorteilhaft, wenn die nicht zu hinterspritzende Lage flächig an einer Wandung des Spritzgusswerkzeugs anliegt, so dass diese Lage zuverlässig nicht in Kontakt mit der Kunststoffmasse kommt.

Es ist ferner möglich, dass die Kunststofflage zwischen der dem zumindest einen Leuchtmittel abgewandten Seite der Trägerlage und der Dekorlage angespritzt wird.

Alternativ kann die Kunststofflage auch zwischen der dem zumindest einen Leuchtmittel zugewandten Seite der Trägerlage und der Dekorlage angespritzt werden.

Dabei werden Träger- und Dekorlage beispielsweise in die jeweils gegenüberliegenden Hälften eines Spritzgusswerkzeugs eingelegt, ohne dass sie in direktem Kontakt stehen und die Kunststofflage in den Zwischenraum zwischen Träger- und Dekorlage eingespritzt. Dazu können sowohl die Trägerals auch die Dekorlage mit einem wärmeaktivierbaren Klebstoff versehen werden, der unter den Druck- und Temperaturbedingungen des Spritzgussvorgangs aktiviert wird.

In diesen beiden Varianten resultiert also ein Sandwichaufbau, bei dem die Kunststofflage von der Trägerlage und der Dekorlage eingeschlossen ist. Dabei können die Leuchtmittel von außen zugänglich bleiben oder vollständig im Kunststoff eingekapselt werden.

Dabei ist es zweckmäßig, wenn die Dekorlage in einer ersten Formhälfte des Spritzgusswerkzeugs und die Trägerlage in einer zweiten Formhälfte des Spritzgusswerkzeugs fixiert wird, insbesondere durch mechanische Klemmmittel und/oder durch Vakuum.

Bevorzugt liegen die jeweiligen Lagen dabei wiederum flächig an einer Innenwandung des Formwerkzeugs an, so dass sie nur einseitig mit der Kunststoffmasse in Kontakt kommen.

Zweckmäßigerweise weist die Dekorlage eine Schichtdicke von 0,1 µm bis 50 µm auf, bevorzugt von 1 µm bis 20 µm.

Die Dekorlage kann dabei als eigenständiges Element bereitgestellt werden, beispielsweise in Form einer Folie, die selbst wiederum mehrere Schichten, beispielsweise Druck- oder Lackschichten, aufweisen kann.

Alternativ kann die Dekorlage durch Drucken, insbesondere durch Aufgießen, Siebdruck, Tiefdruck oder Tampondruck, und/oder durch Lackieren auf der Trägerlage und/oder der Kunststofflage bereitgestellt werden.

Die Trägerlage wird bevorzugt als Folie, insbesondere aus PET (Polyethylen), PEN (Polyethylennaphthalat), PC (Polycarbonat), PVC (Polyvinylchlorid), Kapton® (Poly-oxydiphenylen-pyromellitimid) oder anderen Polyimiden, PLA (Polylactat), PMMA (Polymethylmethacrylat) oder ABS (Acrylnitrilbutadienstyrol), mit einer Schichtdicke von 1 µm bis 500 µm, bevorzugt von 20 µm bis 300 µm bereitgestellt.

Mit solchen Trägerfolien können besonders dünne und gegebenenfalls auch flexible Mehrschichtkörper hergestellt werden.

Alternativ kann die Trägerlage als Leiterplatte, insbesondere aus FR4 (Glasfasergewebe in Epoxidharzmatrix), Polyimid oder Papier, mit einer Schichtdicke von 50 µm bis 2 mm, bevorzugt von 100 µm bis 1,5 mm bereitgestellt werden.

Hierdurch können insbesondere Mehrschichtkörper mit besonders guter mechanischer Stabilität hergestellt werden, die sich auch zum Einsatz unter anspruchsvollen Bedingungen eignen.

Bevorzugt wird zum Spritzgießen der Kunststofflage zumindest eine Kunststoffmasse aus PMMA (Polymethylmethacrylat), ABS (Acrylnitrilbutadienstyrol), PS (Polystyrol), PE (Polyethylen), PP (Polypropylen), PC (Polycarbonat), POM (Polyoxymethylen), PA (Polyamid), ASA(Acrylnitrilstyrolacrylat), SAN (Styrol-Acrylnitril) oder TPU (thermoplastisches Polyurethan) verwendet.

Durch die Wahl des geeigneten Kunststoffmaterials können die Materialeigenschaften des Mehrschichtkörpers je nach dessen gewünschtem Einsatzgebiet über einen weiten Bereich variiert werden.

Es ist dabei auch möglich, mehrere Kunststoffe zu kombinieren, entweder als Gemisch oder im Rahmen eines Mehrkomponenten-Spritzgussverfahrens.

Vorzugsweise wird das Spritzgießen der Kunststofflage in einem vortemperierten Werkzeug bei einer Massetemperatur von 150°C bis 350°C, bevorzugt von 200°C bis 300°C und/oder einem Druck von 500 bar bis 2800 bar, bevorzugt von 700 bar bis 2500 bar durchgeführt.

Es ist vorteilhaft, wenn zum Spritzgießen der Kunststofflage ein Spritzgusswerkzeug verwendet wird, welches eine Kavität mit zumindest zwei bereichsweise ebenen und parallelen Innenwandungen aufweist.
Werden die Trägerlage und die Dekorlage vor dem Spritzgießen der Kunststofflage an eine bzw. beide dieser Innenwandungen angelegt, so kann ein flächiger Mehrschichtkörper erhalten werden.

Alternativ kann zum Spritzgießen der Kunststofflage auch ein Spritzgusswerkzeug verwendet werden, welches eine Kavität mit zumindest einer bereichsweise gekrümmten Innenwandung aufweist.

Auf diese Weise können auch Mehrschichtkörper mit komplexeren dreidimensionalen Geometrien erhalten werden. Die Krümmung kann dabei auch nur bereichsweise vorliegen. Es ist dabei ferner möglich, durch den Einsatz von Schiebern und/oder Kernen innerhalb der Kavität die Geometrie des Mehrschichtkörpers weiter zu beeinflussen. Insgesamt stehen hier alle üblichen, aus dem Spritzguss bekannten Gestaltungsmöglichkeiten zur Verfügung.

Es ist ferner zweckmäßig, wenn als Leuchtmittel SMD-LEDs (SMD = Surface Mounted Device)mit einer Länge von 400 µm bis 20 mm, bevorzugt von 0,6 mm bis 2 mm, einer Breite von 200 µm bis 5 mm, bevorzugt von 0,3 mm bis 1,25 mm, und einer Höhe von 200 µm bis 5 mm, bevorzugt von 0,2 mm bis 1,5 mm, und/oder Chip-LEDs mit einer Länge von 100 µm bis 2 mm, bevorzugt von 0,2 mm bis 0,5 mm, einer Breite von 100 µm bis 2 mm, bevorzugt von 0,2 mm bis 0,5 mm, und einer Höhe von 50 µm bis 250 µm, bevorzugt von 75 µm bis 125 µm, verwendet werden.

Als alternative Leuchtmittel können grundsätzlich auch organische Leuchtdioden (OLED), Light Emitting Cells (LEC) oder Elektrolumineszenz-Displays verwendet werden.

Des Weiteren können neben den Leuchtelementen noch zusätzliche Bauteile, wie z.B. Logikschaltungen, Widerstände, Dioden, Piezolautsprecher, die mit den Leuchtelementen verschaltet werden integriert werden. Die Leuchtelemente werden unter Anderen zur Anzeige von Informationszuständen eingesetzt, alternativ oder zusätzlich lassen sich auch reflektive, nicht selbst leuchtende Anzeigeelemente auf den Träger integrieren, wie z.B. elektrophoretische oder elektrochrome Displays.

Es wird zumindest eine optische Hilfsschicht, insbesondere eine Reflektionsschicht oder Absorptionsschicht, auf die Dekorlage und/oder die Trägerlage und/oder die angespritzte Kunststofflage aufgebracht.

Durch solche Hilfsschichten kann die Lichtführung innerhalb des Mehrschichtkörpers kontrolliert werden. Es ist dabei beispielsweise möglich, einen nur einseitigen Lichtaustritt sicherzustellen oder störendes Streulicht zu vermeiden. Derartige Hilfsschichten können auch lediglich partiell aufgebracht werden und so beispielsweise definierte Austrittsöffnung für das Licht des wenigstens einen Leuchtmittels bereitstellen.

Für die Herstellung von Reflektionsschichten ist es vorteilhaft, wenn die zumindest eine optische Hilfsschicht durch Aufdampfen oder Sputterneines Metalls, insbesondere Aluminium, Silber, Chrom, Kupfer, Gold, oder Legierungen davon mit einer Schichtdicke von 1 nm bis 500 nm, bevorzugt von 5 nm bis 100 nm, erzeugt wird.

Alternativ kann die Reflexionsschicht auch durch Drucken von Metallpigment-haltigen Lacken mit einer Schichtdicke von 0,1 µm bis 50 µm, bevorzugt von 1 µm bis 20 µm, erzeugt werden.

Um Absorptionsschichten aufzubringen, ist es zweckmäßig, wenn die zumindest eine optische Hilfsschicht durch Aufbringen eines pigmentierten Lacks, insbesondere umfassend Rußpigmente, mit einer Schichtdicke von 0,1 µm bis 50 µm, bevorzugt von 1 µm bis 20 µm, erzeugt wird.

Es ist ferner vorteilhaft, wenn die bereitgestellte Dekorlage zumindest einen ersten Bereich, welcher bezüglich des Spektrums des von dem zumindest einen Leuchtmittel emittierten Lichts zumindest teiltransparent ist, und zumindest einen zweiten Bereich, welcher bezüglich des Spektrums des von dem zumindest einen Leuchtmittel emittierten Lichts intransparent, d.h. undurchsichtig bzw. opak ist, umfasst.

Auch so kann der Lichtaustritt aus dem Mehrschichtkörper kontrolliert werden. Die ersten und zweiten Bereiche können dabei einfache Anzeigeflächen oder auch komplexe optische Informationen bilden.

Es ist weiter bevorzugt, wenn die Dekorlage so angeordnet wird, dass das zumindest eine Leuchtmittel senkrecht zur Oberfläche der Dekorlage gesehen in Überdeckung mit dem zumindest einen ersten Bereich kommt.

Auf diese Weise kann ein direkter Lichtaustritt verwirklicht werden. Dies kann beispielsweise zur Punktbeleuchtung von Anzeigeflächen verwendet werden.

Alternativ kann die Dekorlage so angeordnet werden, dass das zumindest ein Leuchtmittel senkrecht zur Oberfläche der Dekorlage gesehen in Überdeckung mit dem zumindest einen zweiten Bereich kommt.

Damit ist kein direkter Lichtaustritt durch den ersten Bereich möglich. Dies kann beispielsweise zur gleichmäßigen Hinterleuchtung von flächigen Strukturen benutzt werden.

Direkte und indirekte Auskoppelung des von dem wenigstens einen Leuchtmittel erzeugten Lichts können selbstverständlich auch kombiniert werden, um ansprechende optische Effekte zu verwirklichen.

Es ist weiter vorteilhaft, wenn dem zum Spritzgießen der Kunststofflage verwendeten Kunststoffmaterial und/oder einem eine Schicht der Trägerlage bildenden Material Farbmittel, insbesondere Farbstoffe und/oder Pigmente und/oder Partikel und/oder Quantenpunktmaterialien und oder phosphoreszierende Materialien, zugesetzt werden, welche im Wellenlängenbereich des von dem zumindest einen Leuchtmittel emittierten Lichts absorbieren und/oder streuen und/oder zur Fluoreszenz oder Phosphoreszenz im sichtbaren Wellenlängenbereich anregbar sind.

Hierdurch kann eine Homogenisierung der Lichtverteilung in der Kunststofflage und/oder Trägerlage erreicht werden. Dies eignet sich insbesondere, um gleichmäßig hinterleuchtete Flächen zu schaffen.

Gleichzeitig oder alternativ kann hiermit, insbesondere bei der Verwendung von fluoreszierenden oder absorbierenden Substanzen oder Quantenpunkten, das Spektrum des von dem wenigstens einen Leuchtmittel emittierten Lichts gezielt beeinflusst werden, so dass vielfältige Farbeffekte geschaffen werden können.

Es ist dabei zweckmäßig, wenn die zugesetzten Farbmittel anorganische Pigmente und/oder Partikel, insbesondere aus Siliziumdioxid, pyrogener Kieselsäure, Titandioxid, Zinksulfid oder einem Metall, mit einer Partikelgröße von 5 nm bis 500 µm, bevorzugt von 500 nm bis 100 µm, umfassen.

Ferner ist es vorteilhaft, wenn eine Oberfläche der Trägerlage mattiert wird.

Auch hierdurch kann die Leuchtdichte über die Trägerlage hinweg homogenisiert werden, um gleichmäßige Leuchtflächen zu erhalten. Auf zusätzliche Diffusoren kann so verzichtet werden.

Es ist weiter vorteilhaft, wenn eine Dekorlage bereitgestellt wird, welche eine Mehrzahl von Bereichen aufweist, die sich in Farbe und/oder Transparenz bezüglich des Spektrums des von dem zumindest einen Leuchtmittel emittierten Licht unterscheiden.

Hierdurch können mehrfarbige grafische Elemente dargestellt werden, deren Erscheinungsbild nicht direkt von der Farbe der verwendeten Leuchtmittel abhängt. Besonders zweckmäßig ist es dabei, wenn eine solche Dekorlage flächig aufgebracht wird, also keine Austrittsöffnungen aufweist. Zudem ist es möglich, auf diese Weise Dekors zu realisieren, die im ausgeschalteten Zustand des wenigstens einen Leuchtmittels nicht sichtbar sind.

Es ist ferner zweckmäßig, wenn auf die Dekorlage eine partielle, bezüglich des Spektrums des von dem zumindest einen Leuchtmittel emittierten Licht intransparente Schicht, insbesondere eine Metallschicht, aufgebracht wird, welche eine optische Information umfasst.

Hiermit wird also eine definierte Austrittsgeometrie für das Licht geschaffen. Dies ist insbesondere zweckmäßig in Verbindung mit einem flächig aufgetragenen Dekor. Auch so kann sichergestellt werden, dass die gewünschte optische Information nur dann sichtbar ist, wenn das wenigstens eine Leuchtmittel Licht abgibt.

Es ist weiter vorteilhaft, wenn eine optisch aktive Reliefstruktur, insbesondere eine diffraktive Struktur, eine Beugungsstruktur Nullter Ordnung, eine Makrostruktur, eine Linsenstruktur, eine Mikrolinsenstruktur, eine Mikroprismenstruktur, in die Dekorlage und/oder die Trägerlage und/oder die Kunststofflage eingebracht wird, insbesondere durch Replikation, insbesondere während der Herstellung der Dekorlage und/oder durch Abformung insbesondere in die Kunststofflage einer im Spritzgusswerkzeug angeordneten Matrize. Die Matrize kann dabei einstückig mit der jeweiligen Formhälfte verbunden sein oder alternativ als separates Einlegeteil oder Einsetzteil ausgeführt sein.

Durch derartige Strukturen kann ebenfalls der Lichtaustritt aus dem Mehrschichtkörper gezielt gesteuert werden. Je nach Art der Reliefstruktur und ihrer relativen Anordnung zu dem wenigstens einen Leuchtmittel kann dabei die Auskoppelung des von dem Leuchtmittel emittierten Lichts bereichsweise gezielt unterstützt oder verhindert werden.

Es ist ferner zweckmäßig, wenn beim Spritzgießen der Kunststofflage zumindest zwei Kunststoffmassen verwendet werden, die sich in einer optischen Eigenschaft, insbesondere in ihrem optischen Brechungsindex, unterscheiden.

Dies kann mit verschiedenen Mehrkomponenten-Spritzgussverfahren durchgeführt werden. Beispielsweise kann das Gießen der unterschiedlichen Kunststoffmassen sequentiell in unterschiedlichen Spritzgusswerkzeugen erfolgen. Alternativ kann aber auch die Geometrie eines Spritzgusswerkzeugs für die sequentiellen Gießschritte verändert werden, beispielsweise durch geeignete Schieber. Auch die Positionierung der Kunststoff- bzw. Trägerlagen auf einem Drehteller, der für die sequentiellen Gießschritte unterschiedliche Werkzeugeinsätze anfährt, ist möglich.

Je nach Geometrie der aus den unterschiedlichen Kunststoffmassen gefertigten Teilbereiche der Kunststofflage, insbesondere je nach Form der Grenzflächen zwischen diesen Teilbereichen, und in Abhängigkeit von der Differenz der Brechungsindices können hierdurch verschiedene Effekte erzielt werden, die ebenfalls der Lichtführung dienen können. Insbesondere können Linseneffekte insbesondere durch Lichtbrechung erzielt werden oder Spiegelflächen durch Totalreflexion an den Grenzflächen geschaffen werden.

Auf die Trägerlage wird eine Leiterbahnschicht zum Kontaktieren des wenigstens einen Leuchtmittels aufgebracht.

Hierdurch kann auf externe Kontaktmittel, wie beispielsweise zusätzliche Leiterbahnplatinen verzichtet werden, was die Herstellung und Montage des Mehrschichtkörpers besonders einfach macht. Mittels der Leiterbahnschicht können auch weitere, gegebenenfalls auf der Trägerlage vorhandene elektronische Komponenten, wie beispielsweise Sensoren, Antennenstrukturen oder dergleichen, kontaktiert werden.

Es ist dabei erfindungsgemäß wenn die Leiterbahnschicht durch Aufdampfen, Sputtern, galvanisches Abscheiden oder Laminieren eines Metalls, insbesondere Aluminium, Silber, Chrom, Kupfer, Gold, oder Legierungen davon, und/oder durch Auftragen leitfähiger Pigmente, Nanopartikel, ITO (Indium-Zinn-Oxid), ATO (Antimon-Zinn-Oxid), leitfähiger organischer Polymere, insbesondere PEDOT (Poly-3,4-ethylendioxythiophen) oder PANI (Polyanilin), Kohlenstoffnanoröhrchen, Graphen oder Ruß mit einer Schichtdicke von 1 nm bis 500 µm, bevorzugt, von 10 nm bis 50 µm, erzeugt wird.

Vorzugsweise umfasst die Leiterbahnschicht zumindest eine Koppelfläche, wobei senkrecht zur Trägerlage gesehen eine komplementäre Koppelfläche auf die dem wenigstens einen Leuchtmittel abgewandte Seite der Trägerlage aufgebracht wird.

Über die komplementären Koppelflächen kann eine Wechselspannung kapazitiv in die Leiterbahnschicht eingekoppelt werden. Es müssen also keine durchgängigen Leiterstrukturen an die Oberfläche des Mehrschichtkörpers geführt werden, um die Leuchtmittel oder andere elektronische Komponenten mit Spannung zu versorgen bzw. Steuersignale an diese zu übermitteln.

Alternativ oder zusätzlich kann die Leiterbahnschicht zumindest eine Spulen- und/oder Antennenstruktur umfassen, wobei senkrecht zur Trägerlage gesehen eine komplementäre Spulen- und/oder Antennenstruktur auf die dem wenigstens einen Leuchtmittel abgewandte Seite der Trägerlage aufgebracht wird.

Auch dies ermöglicht das berührungsfreie Einkoppeln einer Wechselspannung und/oder die Übermittlung von Steuersignalen. In diesem Fall erfolgt die Einkopplung jedoch induktiv.

Es ist ferner möglich, an der Trägerlage zumindest ein elektrisches Kontaktelement anzubringen, welches die Leiterbahnschicht elektrisch kontaktiert und welches beim Spritzgießen der Kunststofflage höchstens teilweise von der Kunststoffmasse eingeschlossen wird.

In diesem Fall erfolgt also eine direkte Kontaktierung der Leiterbahnschicht nach außen. Dies kann gegebenenfalls über geeignete Steckverbinder oder dergleichen erfolgen.

Es ist dabei zweckmäßig, wenn als elektrisches Kontaktelement eine Durchkontaktierung durch die Trägerlage und/oder ein Krimpelement angebracht wird.

Zusätzlich oder alternativ kann beim Spritzgießen der Kunststofflage zumindest ein Teilbereich der Leiterbahnschicht nicht von der Kunststoffmasse eingeschlossen werden und/oder nach dem Spritzgießen der Kunststofflage ein Teilbereich der Trägerlage, auf welchem zumindest ein Teilbereich der Leiterbahnschicht angeordnet ist, von der Kunststofflage abgelöst werden.

Auch so ist eine direkte Kontaktierung der Leiterbahnschicht möglich.

Die Erfindung wird nun anhand von Ausführungsbeispielen näher erläutert. Es zeigen
- Fig. 1: Ein Ausführungsbeispiel eines Mehrschichtkörpers mit einer Dekorlage und einer Trägerlage mit Leuchtelementen sowie mit einer einseitig hinterspritzten Kunststofflage;
- Fig. 2: Ein alternatives Ausführungsbeispiel eines Mehrschichtkörpers mit einer Dekorlage und einer Trägerlage mit Leuchtelementen sowie mit einer zwischen Dekor- und Trägerlage angeordneten Kunststofflage;
- Fig. 3: Eine schematische Ansicht einer optischen Hilfsschicht mit integrierten Leiterbahnen;
- Fig. 4: Ein alternatives Ausführungsbeispiel eines Mehrschichtkörpers mit einer Dekorlage und einer Trägerlage mit Leuchtelementen sowie mit einer zwischen Dekor- und Trägerlage angeordneten Kunststofflage;
- Fig. 5: Ein alternatives Ausführungsbeispiel eines Mehrschichtkörpers mit einer Dekorlage und einer Trägerlage mit Leuchtelementen sowie mit einer einseitig hinterspritzten Kunststofflage;
- Fig. 6: Eine Draufsicht auf ein Ausführungsbeispiel eines Mehrschichtkörpers mit indirekt hinterleuchtetem Dekor;
- Fig. 7: Eine Schnittdarstellung des Mehrschichtkörpers nach Fig. 6;
- Fig. 8: Eine Draufsicht auf ein Ausführungsbeispiel eines Mehrschichtkörpers mit direkt hinterleuchtetem Dekor;
- Fig. 9: Eine Schnittdarstellung des Mehrschichtkörpers nach Fig. 8;
- Fig. 10: Ein alternatives Ausführungsbeispiel eines Mehrschichtkörpers mit Streupartikeln in der Kunststofflage;
- Fig. 11: Ein alternatives Ausführungsbeispiel eines Mehrschichtkörpers mit einem vollflächigen optischen Gitter
- Fig. 12: Ein alternatives Ausführungsbeispiel eines Mehrschichtkörpers mit einem vollflächigen optischen Gitter in der Kunststofflage und der Trägerlage;
- Fig. 13: Ein alternatives Ausführungsbeispiel eines Mehrschichtkörpers mit einem teilflächigen optischen Gitter in der Kunststofflage;
- Fig. 14: Ein alternatives Ausführungsbeispiel eines Mehrschichtkörpers mit einer Mehrkomponenten-Kunststofflage mit Reflektionsstrukturen;
- Fig. 15: Ein alternatives Ausführungsbeispiel eines Mehrschichtkörpers mit einer Mehrkomponenten-Kunststofflage mit Linsenstrukturen;
- Fig. 16: Ein alternatives Ausführungsbeispiel eines Mehrschichtkörpers mit einer Durchkontaktierung durch die Trägerlage;
- Fig. 17: Ein alternatives Ausführungsbeispiel eines Mehrschichtkörpers mit einer seitlichen Krimpverbindung;
- Fig. 18: Ein alternatives Ausführungsbeispiel eines Mehrschichtkörpers mit einer kapazitiven Kontaktierung;
- Fig. 19: Ein alternatives Ausführungsbeispiel eines Mehrschichtkörpers mit einer induktiven Kontaktierung
- Fig. 20: Ein alternatives Ausführungsbeispiel eines Mehrschichtkörpers mit teilweise zugänglicher Leiterbahnschicht;
- Fig. 21: Ein alternatives Ausführungsbeispiel eines Mehrschichtkörpers mit teilweise randständig zugänglicher Leiterbahnschicht;
- Fig. 22: Ein alternatives Ausführungsbeispiel eines Mehrschichtkörpers mit teilweise ablösbarer Trägerlage.

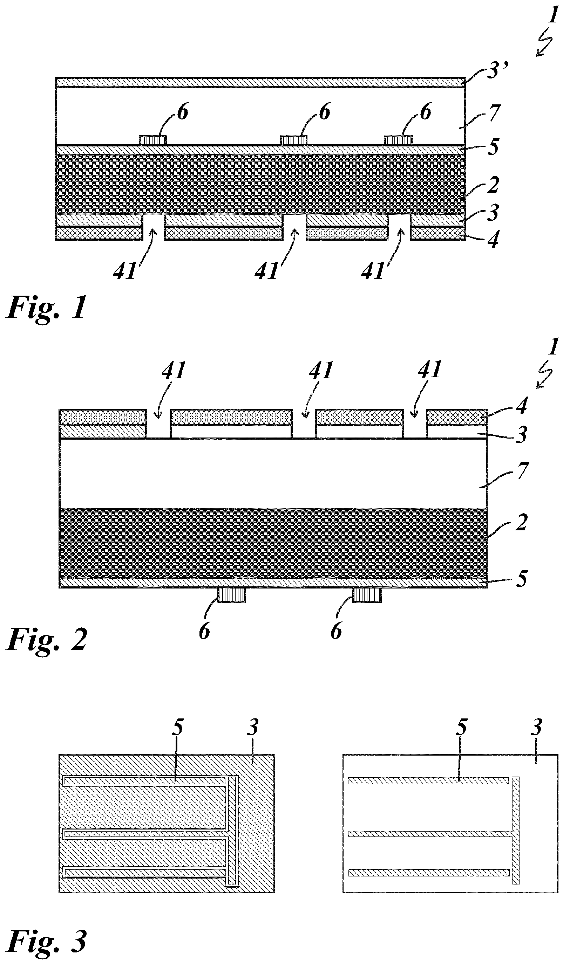

Fig. 1 zeigt ein erstes Ausführungsbeispiel eines Mehrschichtkörpers 1. Dieser umfasst eine Trägerlage 2. Auf einer Seite der Trägerlage 2 ist eine optische Hilfsschicht 3 aufgebracht, auf der wiederum eine Dekorlage 4 angeordnet ist.

In der der Dekorlage 4 sind erfindungsgemäß Aussparungen 41 vorgesehen, die auch die Hilfsschicht 3 durchdringen. Alternativ und hier nicht gezeigt, können in diesen Aussparungen 41 auch optisch transparente Lacke oder andere Materialien angeordnet sein.

Auf der der Hilfsschicht 3 und der Dekorlage 4 abgewandten Seite der Trägerlage 2 ist eine Leiterbahnschicht 5 aufgebracht, mittels welcher Leuchtmittel 6 kontaktiert werden.

Auf Seite der Leuchtmittel 6 ist eine Kunststofflage 7 angespritzt, an die sich eine weitere optische Hilfsschicht 3' anschließt.

Die Trägerlage 2 kann als Folie ausgebildet sein. Bevorzugt besteht diese aus PET, PEN, PC, PVC, Kapton®, PLA, PMMA oder ABS, mit einer Schichtdicke von 1 µm bis 500 µm, bevorzugt von 20 µm bis 300 µm.

Alternativ kann die Trägerlage 2 als Leiterplatte, insbesondere aus FR4, Polyimid oder Papier, mit einer Schichtdicke von 50 µm bis 2 mm, bevorzugt von 100 µm bis 1,5 mm, ausgeführt sein.

Die Hilfsschichten 3, 3' können als Reflektionsschichten oder Absorptionsschichten ausgebildet sein und sollen insbesondere sicherstellen, dass jedes Leuchtmittel 6 nur durch die zugeordnete Aussparung 41 sichtbar ist, so dass Streulicht vermieden wird. Durch eine Reflektionsschicht soll die Lichtausbeute der Leuchtmittel an den Aussparungen verbessert werden, indem seitlich gestreutes Licht in die Aussparungen reflektiert wird.

Reflektionsschichten werden bevorzugt durch Aufdampfen, Sputtern, oder dergleichen eines Metalls, insbesondere Aluminium, Silber, Chrom, Kupfer, Gold, oder Legierungen davon, mit einer Schichtdicke von 1 nm bis 500 nm, bevorzugt von 5 nm bis 100 nm hergestellt.

Für Absorptionsschichten können pigmentierte Lacke, insbesondere umfassend Rußpigmente, mit einer Schichtdicke von 0,1 µm bis 50 µm, bevorzugt von 1 µm bis 20 µm, verwendet werden.

Die Dekorlage 4 kann als Folie ausgeführt sein, insbesondere als Laminier- oder IMD-Folie (IMD = in-mold decoration). Sie weist bevorzugt eine Schichtdicke von 0,1 µm bis 50 µm auf, besonders bevorzugt von 1 µm bis 20 µm.

Alternativ kann es sich bei der Dekorlage 4 auch um eine Druck- oder Lackschicht handeln. Bevorzugt wird diese dann durch Drucken, insbesondere durch Siebdruck, Tiefdruck oder Tampondruck, und/oder durch Lackieren auf der Trägerlage und/oder der Kunststofflage aufgebracht.

Die Dekorlage 4 kann selbst wiederum eine Mehrzahl von Schichten bzw. Bereichen mit unterschiedlichen optischen Eigenschaften aufweisen, so dass auch komplexe visuelle Designs geschaffen werden können. Spezifische Möglichkeiten für die Gestaltung der Dekorlage 4 werden später anhand weiterer Ausführungsbeispiele erläutert.

Die Leiterbahnschicht 5 wird vorzugsweise durch Aufdampfen, Sputtern, galvanisches Abscheiden oder Laminieren eines Metalls, insbesondere Aluminium, Silber, Chrom, Kupfer, Gold, oder Legierungen davon, und/oder durch Auftragen leitfähiger Pigmente, Nanopartikel, ITO, ATO, leitfähiger organischer Polymere, insbesondere PEDOT oder PANI, Kohlenstoffnanoröhrchen, Graphen oder Ruß mit einer Schichtdicke von 1 nm bis 500 µm, bevorzugt von 10 nm bis 50 µm, erzeugt.

Wie Fig. 3 zeigt, kann die Leiterbahnschicht 5 auch in eine optische Hilfsschicht 3 integriert werden und so gleichzeitig optische Eigenschaften bereitstellen. Beispielsweise kann die optische Hilfsschicht eine metallische Reflektionsschicht aus aufgedampftem, aufgesputtertem oder aufgedruckten Metallschichten sein und mittels geeigneter Strukturierung gleichzeitig entsprechend metallisch leitfähige Leiterbahnen bereitstellen.

Bei den Leuchtmitteln 6 handelt es sich um Leuchtdioden. Insbesondere können hierbei SMD-LEDs mit einer Länge von 400 µm bis 20 mm, bevorzugt von 0,6 mm bis 2 mm, einer Breite von 200 µm bis 5 mm, bevorzugt von 0,3 mm bis 1,25 mm, und einer Höhe von 200 µm bis 5 mm, bevorzugt von 0,2 mm bis 1,5 mm, und/oder Chip-LEDs mit einer Länge von 100 µm bis 2 mm, bevorzugt von 0,2 mm bis 0,5 mm, einer Breite von 100 µm bis 2 mm, bevorzugt von 0,2 mm bis 0,5 mm, und einer Höhe von 50 µm bis 250 µm, bevorzugt von 75 µm bis 125 µm, verwendet werden. Als alternative Leuchtmittel können grundsätzlich auch organische Leuchtdioden (OLED), Light Emitting Cells (LEC) oder Elektrolumineszenz-Displays verwendet werden.

Die Kunststofflage 7 wird bevorzugt durch Spritzgießen hergestellt. Hierzu wird der Verbund aus Trägerlage 2 und den darauf angeordneten Lagen 3, 4, 5 sowie den Leuchtmitteln 6 in eine Kavität einer Spritzgussform eingelegt und mit einer Kunststoffmasse hinterspritzt. Um eine bessere Haftung zwischen Trägerlage 2 und Kunststofflage 7 zu schaffen, kann optional auf der der Kunststofflage 7 zugewandten Seite des Verbunds aus Trägerlage 2 und den darauf angeordneten Lagen 3, 4, 5 sowie den Leuchtmitteln 6 eine thermisch aktivierbare Klebeschicht aufgebracht sein.

Als Kunststoffmasse wird dabei vorzugsweise PMMA, ABS, PS, PE, PP, PC, POM, PA, ASA, SAN oder TPU verwendet. Auch Kombinationen dieser Kunststoffe, entweder als Gemisch oder in einem Mehrkomponentenprozess sind möglich.

Das Spritzgießen der Kunststofflage 7 erfolgt dabei in einem vorzugsweise vortemperierten Werkzeug bei einer Massetemperatur von 150°C bis 350°C, bevorzugt von 200°C bis 300°C und/oder einem Druck von 500 bar bis 2800 bar, bevorzugt von 700 bar bis 2500 bar.

Die im Folgenden beschriebenen weiteren Ausführungsbeispiele von Mehrschichtkörpern 1 unterscheiden sich hiervon im Wesentlichen durch die Anzahl, Anordnung und geometrische Ausgestaltung der Lagen und Bauelemente. Die vorstehend beschriebenen Eigenschaften der einzelnen Lagen und Elemente besitzen dabei auch für die folgenden Ausführungsbeispiele Gültigkeit.

In der Ausführungsform nach Fig. 2 ist die Dekorlage 4 und die optische Hilfsschicht auf einer ersten Seite der Kunststofflage 7 angeordnet und die Trägerlage 2 mit der Leiterbahnschicht 5 und den Leuchtmitteln 6 auf der gegenüberliegenden Seite der Kunststofflage 7. Die Leuchtmittel weisen dabei von der Kunststofflage 7 weg und befinden sich in diesem Fall nicht in Überdeckung mit den Aussparungen 41, so dass diese indirekt hinterleuchtet werden.

In dieser Variante wird die Dekorlage 4 zusammen mit der optischen Hilfsschicht 3 durch einen IMD-Prozess direkt auf die Kunststofflage 7 appliziert. Die Trägerlage 2 mit den LEDs 6 wird auf der der Dekorlage 4 gegenüberliegenden Seite des Spritzgusswerkzeugs mit der Trägerlage in Richtung zur Spritzgussmasse eingelegt. Die Dekoration und Applikation der Trägerlage 2 auf die Kunststofflage 7 kann hierbei in einem Arbeitsgang erfolgen.

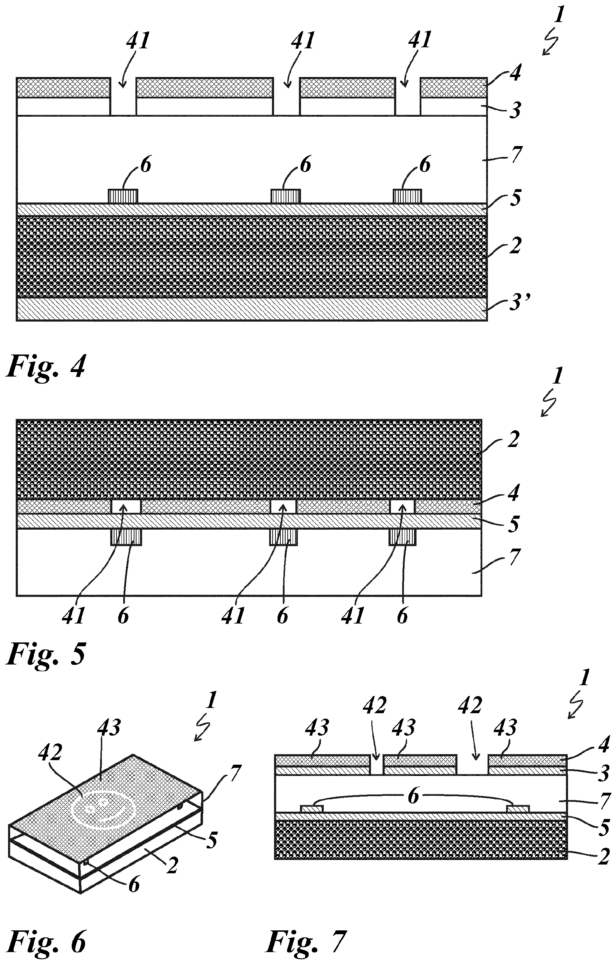

Analog hierzu ist die Ausführungsform nach Fig. 4 aufgebaut. Sie unterscheidet sich von der Ausführungsform nach Fig. 2 lediglich dadurch, dass die Trägerlage 2 mit den Leuchtmitteln 6 und der Leiterbahnschicht 5 zur Kunststofflage 7 hin ausgerichtet ist und dass sich die Leuchtmittel 6 in Überdeckung mit den Aussparungen 41 befinden, so dass diese direkt hinterleuchtet werden. Auf der den Leuchtmitteln 6 abgewandten Seite der Trägerlage 2 ist dabei eine weitere Hilfsschicht 3' angeordnet, die den Lichtaustritt auf dieser Seite verhindert und/oder das nach hinten reflektierte Licht nach vorne spiegelt, um die Lichtausbeute zu verbessern. Soll jedoch Streulicht von benachbarten Leuchtmitteln in den Aussparungen vermieden werden, wird diese optischen Hilfsschicht 3' absorbierend ausgeführt.

In der Ausführungsform nach Fig. 5 ist die Kunststofflage 7 wie in der Ausführungsform nach Fig. 1 einseitig angespritzt. Im Unterschied zu Fig. 1 sind hier allerdings Dekorlage 4, Leiterbahnschicht 5 und Leuchtelemente 6 auf der gleichen Seite der Trägerlage 2 angeordnet und zur Kunststofflage 7 hin ausgerichtet. Auf optische Hilfsschichten 3, 3' wird hier verzichtet.

Fig. 6 zeigt eine Aufsicht auf eine weitere Ausführungsform eines Mehrschichtkörpers 1. Der gleiche Mehrschichtkörper 1 ist in Fig. 7 in einer schematischen Schnittansicht gezeigt. Das Licht der LEDs 6 wird hier indirekt ausgekoppelt. Diese sind vorzugsweise nicht unterhalb einer Aussparung 41 in der Dekorlage 4 positioniert. Dies kann besonders vorteilhaft sein, wenn das Licht über größere oder verteilte kleinere Austrittsöffnungen 41 homogen verteilt werden soll. In diesem Fall ist es vorteilhaft, wenn die optionalen optischen Hilfsschichten 3, 3' spiegelnd, beispielsweise als spiegelnd aufgedampfte oder aufgesputterte Metallschicht, ausgelegt werden, damit möglichst viel Licht in die Austrittsöffnungen 41 reflektiert wird.

Manchmal wird aus gestalterischen Gründen gefordert, dass die Leuchtstrukturen bei ausgeschalteten LEDs 6 nicht sichtbar sind, oder dass die Dekorlagen 4 im eingeschalteten Zustand die Farbe des LED-Lichtes verändern. Dies kann erreicht werden, indem die Dekorlage 4wie in Fig. 6 gezeigt durchgehend über den LEDs 6 ausgeführt ist. Dabei kann die Dekorlage Bereiche 42, 43 mit unterschiedliche Farben, Strukturen und Transparenzen aufweisen, die das gewünschte Dekor bilden.

Besonders, wenn die Oberfläche einfarbig ist und die zu zeigenden Strukturen nur im eingeschalteten Zustand der LEDs6 sichtbar aufleuchten sollen, ist es vorteilhaft, die Dekorlage 4 durchgängig zu drucken. Die Leuchtstrukturen werden dabei bevorzugt über einer metallischen oder besonders lichtdichten Schicht 3 erzeugt, die die zu zeigende Struktur als Aussparungen enthält (d.h. die eine Schattenmaske unterhalb der Dekorlage 4 bildet). Dabei kann die in Fig. 1 gezeigte Schichtfolge eingesetzt werden, mit dem Unterschied, dass die Dekorlage 4 ohne Aussparungen 41 gedruckt ist.

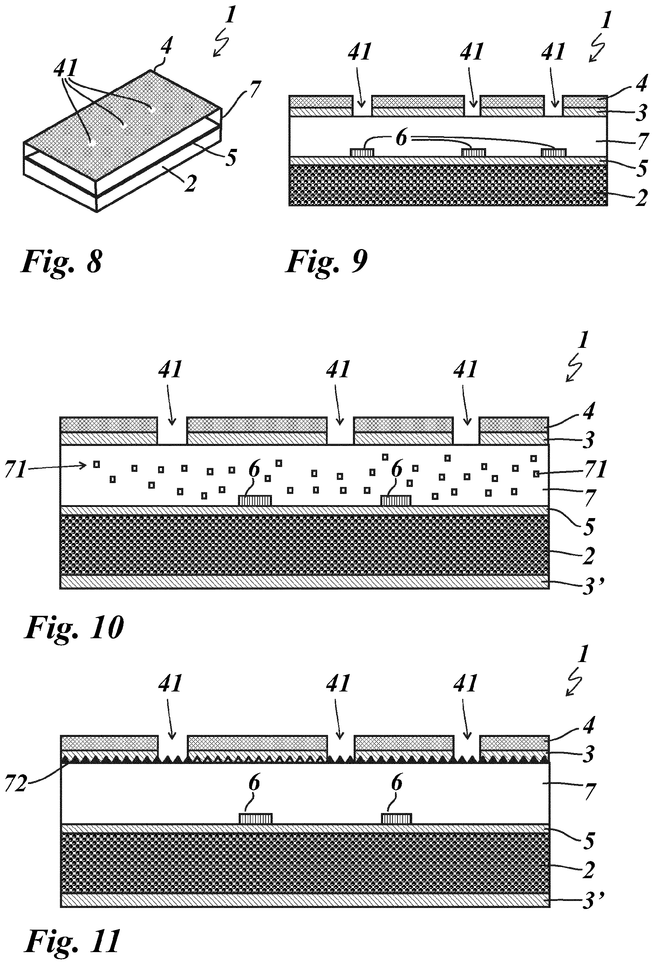

Sollen die LEDs 6 direkt sichtbar sein, z.B. als Indikatoren, kann die Dekorlage 4 direkt über den LEDs 6 in Blickrichtung Aussparungen 41 enthalten, wie in den Figuren 8 und 9 dargestellt. Dabei sollten die außerhalb des direkten Strahlengangs der LEDs 6 liegenden optischen Hilfsschichten 3, 3' möglichst lichtabsorbierend ausgelegt sein, um zu verhindern, dass in benachbarten Aussparungen 41 Licht austritt (Crosstalk bzw. optisches "Übersprechen").

Will man einen flächig homogenen Lichteffekt erzielen, z.B. wenn die LEDs 6 einen Schriftzug hinterleuchten sollen, benötigt man eine möglichst homogene Lichtverteilung. Eine Homogenisierung des Lichtes kann durch die Verwendung von vielen LEDs 6 (sehr aufwendig und kostenintensiv) oder durch den Einsatz von Streupartikeln 71, und/oder homogen verteilten Fluoreszenzfarbstoffen in der Spritzgussmasse der Kunststofflage 7 und/oder der Trägerlage 2 erreicht werden. Dies ist in Fig. 10 dargestellt.

Dabei können durch die Einfärbung des Materials und/oder Fluoreszenz zusätzlich Farbeffekte erzeugt werden. Optional zu löslichen Fluoreszenzfarbstoffen können auch unlösliche Fluoreszenzpigmente eingesetzt werden, die dann gleichzeitig als lichtstreuende Partikel 71 dienen.

Die lichtstreuenden Partikel 71 können dabei anorganische Pigmente und/oder Partikel, insbesondere aus Siliziumdioxid, pyrogener Kieselsäure, Titandioxid, Zinksulfid oder einem Metall, mit einer Partikelgröße von 5 nm bis 500 µm, bevorzugt von 500 nm bis 100 µm, umfassen.

In die Kunststofflage 7 und/oder die Dekorlage 4 können feine optische Gitter 72 eingearbeitet sein, die die Auskopplung des Lichtes verhindern oder unterstützen. Hierfür eignen sich bevorzugt Subwellenlängengitter, aber auch vergleichsweise tiefe und/oder grobe Strukturen wie insbesondere refraktiv wirkende Mikroprismen. Bevorzugte Gitterparameter sind dabei für Subwellenlängengitter eine Periode bevorzugt von 200 nm bis 500 nm sowie eine Gittertiefe bevorzugt von 100 nm bis 500 nm. Der Gittertyp wird hierbei bevorzugt aus der Reihe Linear-, Kreuz- oder Hexagonalgitter gewählt. Bei Verwendung von Mikroprismen beträgt die laterale Ausdehnung dx bzw. dy der Prismen 1 µm bis 100 µm, bevorzugt 5 µm bis 50 µm. Die Strukturtiefe beträgt bevorzugt in etwa das 0,3- bis 2-fache der lateralen Ausdehnung. Die Anordnung der Mikroprismen kann sowohl regelmäßig, also periodisch als auch zufällig sowie pseudozufällig sein.

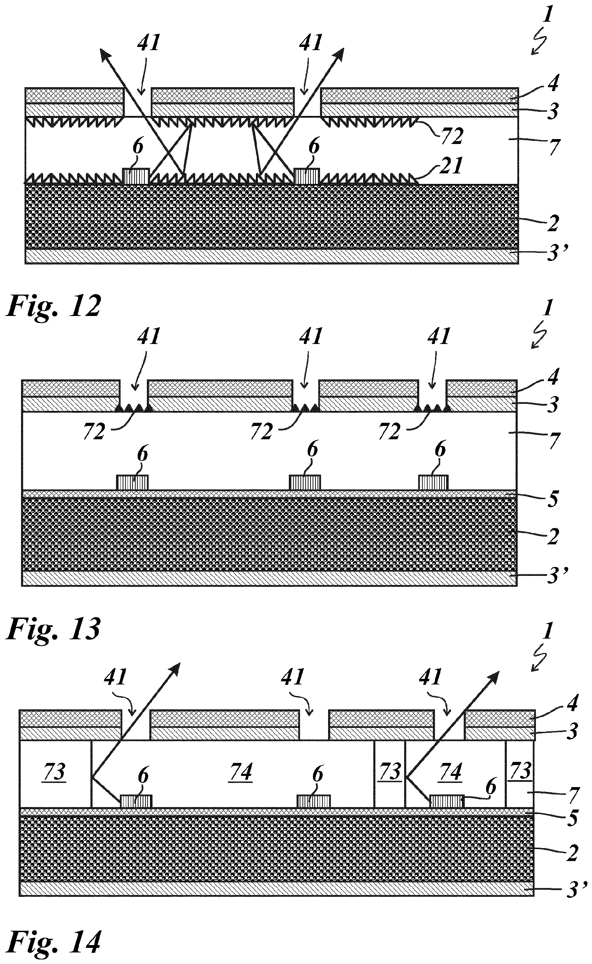

Dabei können die optischen Gitter 72 vollflächig (siehe Fig. 11) oder nur im Bereich der Aussparungen 41 (siehe Fig. 13) in der Dekorlage 4 und/oder der optischen Hilfsschicht 3 und/oder der Kunststofflage 7angeordnet sein.

Die Erzeugung erfolgt z.B. mittels Replikation oder aber durch Strukturierung des Spritzgusswerkzeuges, so dass die Gitter 72 beim Spritzgießen der Kunststofflage 7 abgeformt werden.

Als weitere Variante kann optional ein weiteres optisches Gitter 21 auf der Trägerlage 2 ausgeführt sein, wie in Fig. 12 gezeigt. Hierbei sind die Aussparungen 41 nicht von dem Gitter 72 bedeckt. Die Pfeile geben einen möglichen Strahlengang des von den LEDs 6 emittierten Lichts an.

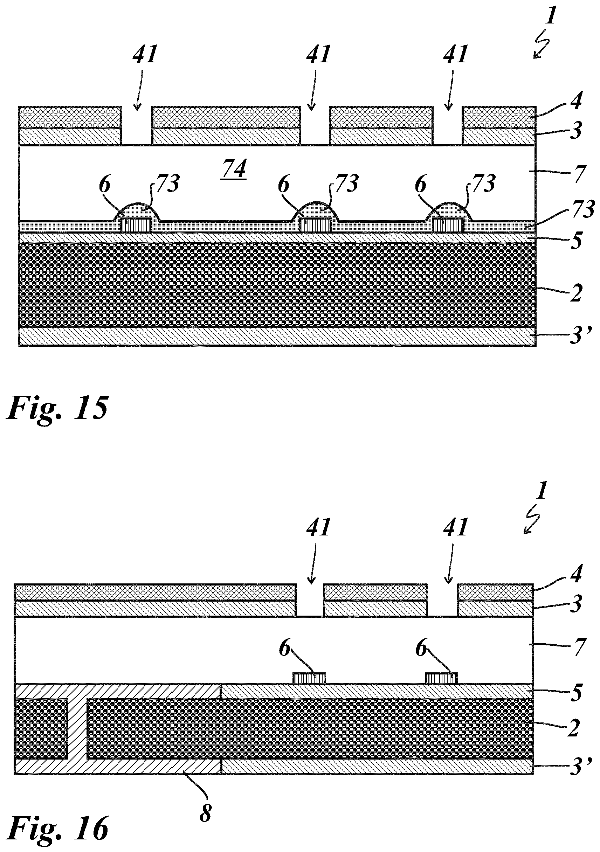

Ferner kann die Verwendung von zwei unterschiedlichen Spritzgussmassen mit unterschiedlichem optischen Brechungsindex, die jeweils Teilbereiche 73, 74 der Kunststofflage 7 bilden, dazu genutzt werden, um Linseneffekte, insbesondere durch Lichtbrechung zu erzeugen, wie in Fig. 15 dargestellt, oder aber das Licht an Grenzflächen zu reflektieren, wie in Fig. 14 gezeigt. Zum Beispiel kann so Crosstalk, d.h. ein optisches "Übersprechen" zwischen mehreren Austrittsöffnungen 41 verhindert werden oder die Lichtausbeute an den Austrittsöffnungen 41 verbessert werden.

Die Kunststofflage 7 wird in diesen Fällen durch Zweikomponenten-Spritzguss geformt. Entweder werden die Bereiche 73, 74 in getrennten Werkzeugen eingespritzt, d.h. zuerst wird der Bereich 73 auf die LEDs 6 gespritzt, das Werkstück entnommen und in ein zweites Werkzeug eingelegt. Dort wird dann der Bereich 74 angespritzt.

Eine weitere Möglichkeit ist die Verwendung eines Drehtellers. Dabei wird zunächst z.B. der Bereich 73 gespritzt. Dann wird das Werkzeug geöffnet und das Bauteil rotiert mit dem Drehteller um eine halbe Drehung weiter, so dass es einem zweiten Werkzeugeinsatz gegenüberliegt. Dort wird dann der Bereich 74 angespritzt.

Simultan dazu wird an einem zweiten Werkstück der Bereich 73 angebracht. Nach dem Spritzen von Bereich 74 am ersten Werkstück wird das fertige erste Werkstück entfernt und der Drehteller rotiert erneut um eine halbe Drehung.

Ebenfalls denkbar ist die Verwendung eines Werkzeuges, bei dem sich die Kavität durch Verwendung von Schiebern ändern lässt.

Die folgenden Ausführungsbeispiele betreffen die elektrische Kontaktierung der Leiterbahnschicht 5. Diese kann durch direkten galvanischen Kontakt aber auch berührungslos realisiert werden.

Zur direkten Kontaktierung kann beispielsweise eine Durchkontaktierung 8 (VIA, vertical interconnect access) durch die Trägerlage 2 angebracht werden, wie in Fig. 16 gezeigt. Dadurch entsteht eine direkte Verbindung der Stromzuführung mit der Leiterbahnschicht. Erzeugen lässt sich eine solche Durchkontaktierung 8 zum Beispiel galvanisch, durch eine gezielte Abscheidung von Metall innerhalb eines zuvor erzeugten Loches innerhalb der Trägerlage 2 oder aber durch Einstanzen eines Metallstiftes. Denkbar ist auch der Einsatz einer KrimpTechnik. Beides geschieht, bevor die Trägerlage 2 im Spritzguss verarbeitet wird.

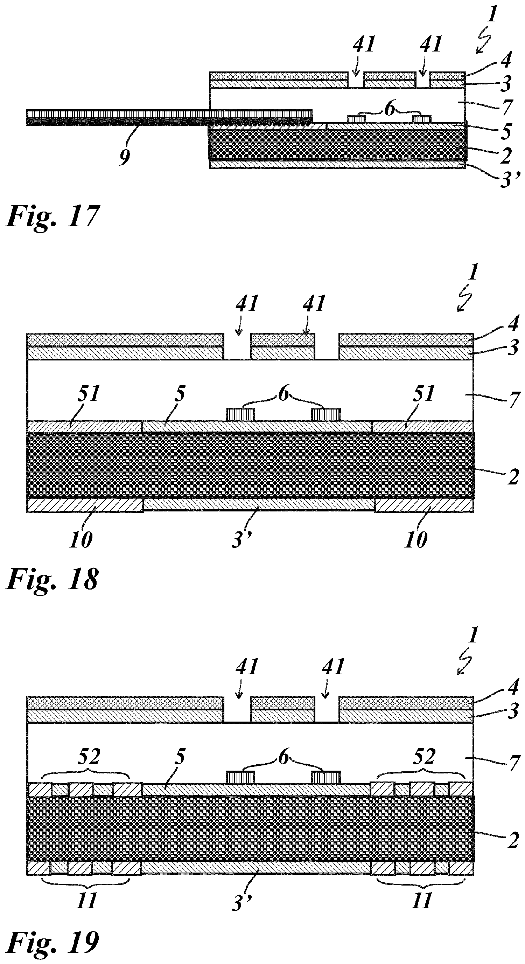

Eine weitere Möglichkeit zur Kontaktierung mittels Krimpen stellt die Verwendung eines zweiten Leiterbahnsubstrates 9 dar, welches wie in Fig. 17 gezeigt, auf Seiten der Leiterbahnschicht 5 auf der Trägerlage 2 platziert und mittels Krimptechnik verankert wird.

Auf diese Weise lässt sich die Kontaktierung seitlich von dem Mehrschichtkörper 1 abführen. Diese mechanisch hergestellte Verbindung kann entweder in einem separaten Schritt vor dem Spritzgussvorgang hergestellt werden oder aber während diesem, mit Hilfe eines integrierten Krimpwerkzeuges.

Zur Verbindung der Leiterbahnsubstrate kommen nicht nur mechanische Verbindungstechniken in Frage, sondern auch Kleben oder Löten. Innerhalb des Prozesses kann dieser Schritt separat vor dem Hinterspritzvorgang durchgeführt werden.

Eine indirekte Kontaktierung der Leiterbahnschicht 5 kann kapazitiv erfolgen, wie in Fig. 18 gezeigt. Grundlage der kapazitiven Kopplung sind zwei Koppelflächen 51 innerhalb der Leiterbahnschicht 5 die jeweils zumindest bereichsweise über zugeordneten außerhalb gelegenen Koppelflächen 10 positioniert sein müssen. Bei Anlegen eines elektrischen Wechselfeldes baut sich an den durch die jeweils übereinander liegenden Koppelflächen 10, 51 gebildeten Kondensatoren ein gegenläufiges Feld auf, so dass ein Strom durch die von der Leiterbahnschicht 5 kontaktierten Verbraucher fließen kann. Anstelle von übereinander liegenden Koppelflächen können auch analog dazu angeordnete Antennenstrukturen 52, 11 angewendet werden, um so eine induktive Kopplung zu verwirklichen. Idealerweise sind diese so abgestimmt, dass die externe Sendeantenne 11 in Resonanz zu der internen Empfangsantenne 52 arbeitet. Der grundlegende Aufbau ist Fig. 19 dargestellt. Auch in diesem Beispiel wird über die induktive Kopplung ein Wechselstrom in der Leiterbahnschicht 5 erzeugt, ohne dass diese direkt kontaktiert werden muss. Eine Gleichrichtung kann ebenfalls mittels geeigneter Bauteile erfolgen. In Abhängigkeit von Größe und Form der Antennen 11, 52 lassen sich zudem die Resonanzfrequenz und Reichweite einstellen. Über Modulation des Signals lassen sich außerdem Informationen oder Steuerbefehle an die auf der Trägerschicht integrierten, eingeschlossene Elektronik übertragen. Die externe Antenne 52 kann ebenfalls direkt auf der Trägerschicht 2 aufgebracht oder aber nach Fertigstellung des Mehrschichtkörpers 1 angebracht werden.

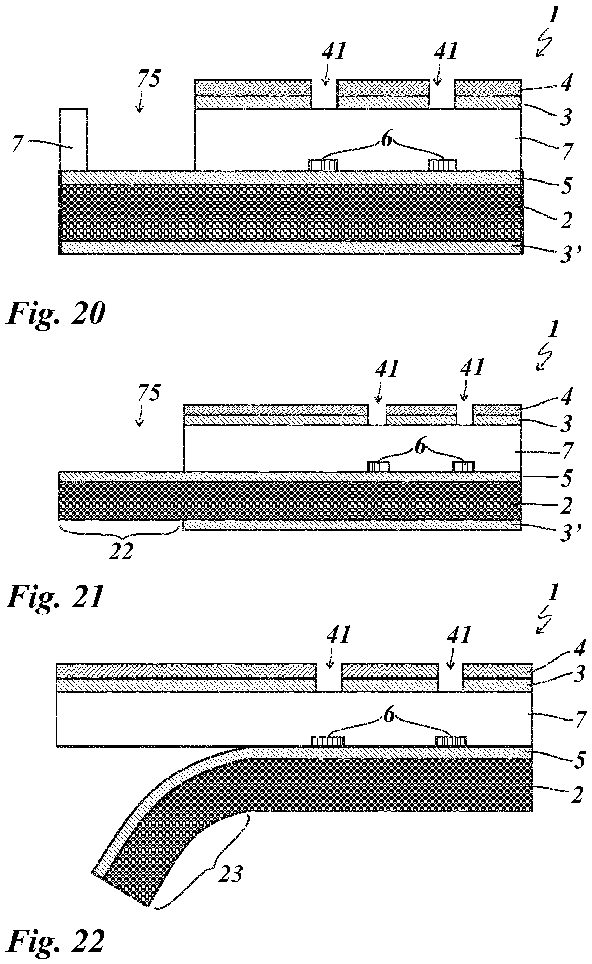

Eine weitere Möglichkeit zur direkten Kontaktierung der Leiterbahnschicht 5 besteht darin, diese während des Spritzgießens der Kunststofflage 7 nicht vollständig mit Kunststoff einzuschließen. Dabei kann entweder eine Aussparung 75 in der Kunststofflage 7 offen gelassen werden, wie in Fig. 20 gezeigt, oder die Kunststofflage 7 nicht bis zum Rand der Trägerlage 2 aufgebracht werden, so dass sich eine überstehende Lasche 22 der Trägerlage ergibt, auf der die Leiterbahnschicht 5 kontaktiert werden kann (siehe Fig. 21).

Alternativ kann auch, wie in Fig. 22 dargestellt, nach dem Spritzgießen der Kunststofflage 7 ein Teilbereich 23 der Trägerlage 2, auf den sich die Leiterbahnschicht 5 erstreckt, von der Kunststofflage 7 abgelöst werden. Hierzu kann gegebenenfalls vor dem Spritzgießen eine entsprechende Ablöseschicht auf den Teilbereich 23 aufgebracht werden. Die Ablöseschicht besteht bevorzugt aus einem Wachs, einem Siloxanpolymer oder einem fluorhaltigen Polymer (z.B. Teflon®) und weist eine Schichtdicke von 10 nm bis 5 µm, bevorzugt von 100 nm bis 1 µm auf.

### Bezugszeichenliste

- 1: Mehrschichtkörper
- 2: Trägerlage
- 3, 3': optische Hilfsschicht
- 4: Dekorlage
- 5: Leiterbahnschicht
- 6: Leuchtmittel
- 7: Kunststofflage
- 8: Durchkontaktierung
- 9: Leiterbahnsubstrat
- 10: Koppelfläche
- 11: Antennenstruktur
- 21: Gitterstruktur
- 22: Lasche
- 23: ablösbarer Bereich der Trägerlage
- 41: Aussparung
- 42, 43: Bereich der Trägerlage
- 51: Koppelfläche
- 52: Antennenstruktur
- 71: Streupartikel
- 72: Gitterstruktur
- 73, 74: Bereich der Kunststofflage
- 75: Aussparung

## Patentansprüche

1. Verfahren zum Herstellen eines Mehrschichtkörpers, mit den Schritten:
a) Bereitstellen einer Trägerlage, auf der zumindest eine LED angeordnet wird;
b) Bereitstellen einer Dekorlage;
c) Anspritzen einer Kunststofflage an die Trägerlage und/oder die Dekorlage in einem Spritzgusswerkzeug;
und dass auf die Trägerlage eine Leiterbahnschicht zum Kontaktieren des wenigstens einen Leuchtmittels aufgebracht wird, wobei die Leiterbahnschicht durch Aufdampfen, Sputtern, galvanisches Abscheiden oder Laminieren eines Metalls und/oder durch Auftragen von leitfähiger Pigmente, Nanopartikel, ITO, ATO, leitfähiger organischer Polymere, Kohlenstoffnanoröhrchen, Graphen oder Ruß mit einer Schichtdicke von 10 nm bis 50 µm erzeugt wird
und wobei die Leiterbahnschicht zumindest eine Koppelfläche umfasst, wobei senkrecht zur Trägerlage gesehen eine komplementäre Koppelfläche auf die dem wenigstens einen Leuchtmittel abgewandte Seite der Trägerlage aufgebracht wird und/oder wobei die Leiterbahnschicht zumindest eine Spulen- und/oder Antennenstruktur umfasst, wobei senkrecht zur Trägerlage gesehen eine komplementäre Spulen- und/oder Antennenstruktur auf die dem wenigstens einen Leuchtmittel abgewandte Seite der Trägerlage aufgebracht wird und/oder wobei an der Trägerlage zumindest ein elektrisches Kontaktelement angebracht wird, welches die Leiterbahnschicht elektrisch kontaktiert und welches beim Spritzgießen der Kunststofflage höchstens teilweise von der Kunststoffmasse eingeschlossen wird
und/oder wobei beim Spritzgießen der Kunststofflage zumindest ein Teilbereich der Leiterbahnschicht nicht von der Kunststoffmasse eingeschlossen wird und/oder nach dem Spritzgießen der Kunststofflage ein Teilbereich der Trägerlage, auf welchem zumindest ein Teilbereich der Leiterbahnschicht angeordnet ist, von der Kunststofflage abgelöst wird,
und dass zumindest eine optische Hilfsschicht auf die Dekorlage und/oder die Trägerlage und/oder die angespritzte Kunststofflage aufgebracht wird
und dass in der Dekorlage Aussparungen vorgesehen sind, die auch die optische Hilfsschicht durchdringen.

2. Verfahren nach Anspruch 1,
**dadurch gekennzeichnet,**
**dass** die Dekorlage auf die Trägerlage aufgebracht wird, wobei bevorzugt die Dekorlage auf die dem zumindest einen Leuchtmittel abgewandte Seite der Trägerlage oder auf die dem zumindest einen Leuchtmittel zugewandte Seite der Trägerlage, insbesondere zwischen dem Leuchtmittel und der Trägerlage, aufgebracht wird, und/oder wobei bevorzugt die Dekorlage und die Trägerlage in einer Formhälfte des Spritzgusswerkzeugs fixiert werden, insbesondere durch mechanische Klemmmittel und/oder Vakuum, und einseitig hinterspritzt werden.

3. Verfahren nach Anspruch 1,
**dadurch gekennzeichnet,**
**dass** die Kunststofflage zwischen der dem zumindest einen Leuchtmittel abgewandten Seite der Trägerlage und der Dekorlage oder zwischen der dem zumindest einen Leuchtmittel zugewandten Seite der Trägerlage und der Dekorlage angespritzt wird, wobei bevorzugt die Dekorlage in einer ersten Formhälfte des Spritzgusswerkzeugs und die Trägerlage in einer zweiten Formhälfte des Spritzgusswerkzeugs fixiert wird, insbesondere durch mechanische Klemmmittel und/oder Vakuum.

4. Verfahren nach einem der Ansprüche 1 bis 3,
**dadurch gekennzeichnet,**
**dass** die Trägerlage als Leiterplatte, insbesondere aus FR4, Polyimid oder Papier, mit einer Schichtdicke von 50 µm bis 2 mm, bevorzugt von 100 µm bis 1,5 mm bereitgestellt wird.

5. Verfahren nach einem der Ansprüche 1 bis 4,
**dadurch gekennzeichnet,**
**dass** als Leuchtmittel SMD-LEDs mit einer Länge von 400 µm bis 20 mm, bevorzugt von 0,6 mm bis 2 mm, einer Breite von 200 µm bis 5 mm, bevorzugt von 0,3 mm bis 1,25 mm, und einer Höhe von 200 µm bis 5 mm, bevorzugt von 0,2 mm bis 1,5 mm, und/oder Chip-LEDs mit einer Länge von 100 µm bis 2 mm, bevorzugt von 0,2 mm bis 0,5 mm, einer Breite von 100 µm bis 2 mm, bevorzugt von 0,2 mm bis 0,5 mm, und einer Höhe von 50 µm bis 250 µm, bevorzugt von 75 µm bis 125 µm, verwendet werden.

6. Verfahren nach einem der Ansprüche 1 bis 5,
**dadurch gekennzeichnet,**
**dass** zumindest eine optische Hilfsschicht, insbesondere eine Reflektionsschicht oder Absorptionsschicht, auf die Dekorlage und/oder die Trägerlage und/oder die angespritzte Kunststofflage aufgebracht wird, wobei die zumindest eine optische Hilfsschicht durch Aufdampfen oder Sputtern eines Metalls, insbesondere Aluminium, Silber, Chrom, Kupfer, Gold, oder Legierungen davon, mit einer Schichtdicke von 1 nm bis 500 nm, bevorzugt von 5 nm bis 100 nm, erzeugt wird, oder durch Drucken von Metallpigment-haltigen Lacken mit einer Schichtdicke von 0,1 µm bis 50 µm, bevorzugt von 1 µm bis 20 µm, erzeugt wird, und/oder wobei die zumindest eine optische Hilfsschicht durch Aufbringen eines pigmentierten Lacks, insbesondere umfassend Rußpigmente, mit einer Schichtdicke von 0,1 µm bis 50 µm, bevorzugt von 1 µm bis 20 µm, erzeugt wird.

7. Verfahren nach einem der Ansprüche 1 bis 6,
**dadurch gekennzeichnet,**
**dass** die bereitgestellte Dekorlage zumindest einen ersten Bereich, welcher bezüglich des Spektrums des von dem zumindest einen Leuchtmittel emittierten Lichts zumindest teiltransparent ist, und zumindest einen zweiten Bereich, welcher bezüglich des Spektrums des von dem zumindest einen Leuchtmittel emittierten Lichts intransparent ist, umfasst, wobei bevorzugt die Dekorlage so angeordnet wird, dass das zumindest eine Leuchtmittel senkrecht zur Oberfläche der Dekorlage gesehen in Überdeckung mit dem zumindest einen ersten Bereich kommt, und/oder wobei bevorzugt die Dekorlage so angeordnet wird, dass das zumindest eine Leuchtmittel senkrecht zur Oberfläche der Dekorlage gesehen in Überdeckung mit dem zumindest einen zweiten Bereich kommt.

8. Verfahren nach einem der Ansprüche 1 bis 7,
**dadurch gekennzeichnet,**
**dass** dem zum Spritzgießen der Kunststofflage verwendeten Kunststoffmaterial und/oder einem eine Schicht der Trägerlage bildenden Material Farbmittel, insbesondere Farbstoffe und/oder Pigmente und/oder Partikel und/oder Quantenpunktmaterialien, zugesetzt werden, welche im Wellenlängenbereich des von dem zumindest einen Leuchtmittel emittierten Lichts absorbieren und/oder streuen und/oder zur Fluoreszenz oder Phosphoreszenz im sichtbaren Wellenlängenbereich anregbar sind, wobei insbesondere die zugesetzten Farbmittel anorganische Pigmente und/oder Partikel, insbesondere aus Siliziumdioxid, pyrogener Kieselsäure, Titandioxid, Zinksulfid oder einem Metall, mit einer Partikelgröße von 5 nm bis 500 µm, bevorzugt von 500 nm bis 100 µm, umfassen.

9. Verfahren nach einem der Ansprüche 1 bis 8,
**dadurch gekennzeichnet,**
**dass** eine Dekorlage bereitgestellt wird, welche eine Mehrzahl von Bereichen aufweist, die sich in Farbe und/oder Transparenz bezüglich des Spektrums des von dem zumindest einen Leuchtmittel emittierten Licht unterscheiden und/ oder dass auf die Dekorlage eine partielle, bezüglich des Spektrums des von dem zumindest einen Leuchtmittel emittierten Licht intransparente Schicht, insbesondere eine Metallschicht, aufgebracht wird, welche eine optische Information umfasst.

10. Verfahren nach einem der Ansprüche 1 bis 9,
**dadurch gekennzeichnet,**
**dass** eine optisch aktive Reliefstruktur, insbesondere eine diffraktive Struktur, eine Beugungsstruktur Nullter Ordnung, eine Makrostruktur, eine Linsenstruktur, eine Mikrolinsenstruktur, eine Mikroprismenstruktur, in die Dekorlage und/oder die Trägerlage und/oder die Kunststofflage eingebracht wird, insbesondere durch Replikation und/oder durch Abformung einer im Spritzgusswerkzeug angeordneten Matrize und/oder dass beim Spritzgießen der Kunststofflage zumindest zwei Kunststoffmassen verwendet werden, die sich in einer optischen Eigenschaft, insbesondere in ihrem Brechungsindex, unterscheiden.

11. Verfahren nach einem der Ansprüche 1 bis 10,
**dadurch gekennzeichnet,**
**dass** auf die Trägerlage eine Leiterbahnschicht zum Kontaktieren des wenigstens einen Leuchtmittels aufgebracht wird, wobei die Leiterbahnschicht durch Aufdampfen, Sputtern, galvanisches Abscheiden oder Laminieren von Aluminium, Silber, Chrom, Kupfer, Gold, oder Legierungen davon, und/oder durch Auftragen von PEDOT oder PANI mit einer Schichtdicke von 10 nm bis 50 µm, erzeugt wird.

12. Mehrschichtkörper, hergestellt mittels eines Verfahrens nach einem der Ansprüche 1 bis 11, mit einer Trägerlage, auf der zumindest eine LED angeordnet ist, einer Dekorlage und einer angespritzten Kunststofflage, insbesondere aus PMMA, ABS, PS, PE, PP, PC, POM, PA, ASA, SAN oder TPU, wobei bevorzugt die Dekorlage auf die dem zumindest einen Leuchtmittel abgewandte oder zugewandten Seite der Trägerlage angeordnet ist, oder wobei bevorzugt die Kunststofflage zwischen der dem zumindest einen Leuchtmittel abgewandten oder zugewandten Seite der Trägerlage und der Dekorlage angeordnet ist.

13. Mehrschichtkörper nach Anspruch 12,
**dadurch gekennzeichnet,**
**dass** zumindest eine optische Hilfsschicht, insbesondere eine Reflektionsschicht aus einem Metall, insbesondere Aluminium, Silber, Chrom, Kupfer, Gold, oder Legierungen davon, mit einer Schichtdicke von 1 nm bis 500 nm, bevorzugt von 5 nm bis 100 nm, oder eine Absorptionsschicht, aus einem pigmentierten Lack, insbesondere umfassend Rußpigmente, mit einer Schichtdicke von 0,1 µm bis 50 µm, bevorzugt von 1 µm bis 20 µm, auf der Dekorlage und/oder der Trägerlage und/oder der angespritzte Kunststofflage angeordnet ist.

14. Mehrschichtkörper nach einem der Ansprüche 12 oder 13,
**dadurch gekennzeichnet,**
**dass** die Dekorlage zumindest einen ersten Bereich, welcher bezüglich des Spektrums des von dem zumindest einen Leuchtmittel emittierten Lichts zumindest teiltransparent ist, und zumindest einen zweiten Bereich, welcher bezüglich des Spektrums des von dem zumindest einen Leuchtmittel emittierten Lichts intransparent ist, umfasst, wobei die Dekorlage so angeordnet ist, dass das zumindest eine Leuchtmittel senkrecht zur Oberfläche der Dekorlage gesehen in Überdeckung mit dem zumindest einen ersten Bereich und/oder mit dem zumindest einen zweiten Bereich kommt und/oder die Dekorlage eine Mehrzahl von Bereichen aufweist, die sich in Farbe und/oder Transparenz bezüglich des Spektrums des von dem zumindest einen Leuchtmittel emittierten Licht unterscheiden und/oder die Dekorlage und/oder die Trägerlage und/oder die Kunststofflage eine diffraktive Gitterstruktur umfasst.

15. Mehrschichtkörper nach einem der Ansprüche 12 bis 14,
**dadurch gekennzeichnet,**
**dass** die Trägerlage eine Leiterbahnschicht zum Kontaktieren des wenigstens einen Leuchtmittels, welche insbesondere aus einem Metall, insbesondere Aluminium, Silber, Chrom, Kupfer, Gold, oder Legierungen davon, und/oder aus leitfähigen Pigmenten, Nanopartikeln, ITO, ATO, leitfähigen organischen Polymeren, insbesondere PEDOT oder PANI, Kohlenstoffnanoröhrchen, Graphen oder Ruß mit einer Schichtdicke von 1 nm bis 500 µm, bevorzugt von 10 nm bis 50 µm, ausgebildet ist, wobei bevorzugt die Leiterbahnschicht zumindest ein elektrisches Kontaktelement umfasst, insbesondere eine Koppelfläche und/oder Spulenstruktur und/oder Antennenstruktur, die in Überdeckung zu einer komplementären Koppelfläche und/oder Spulenstruktur und/oder Antennenstruktur auf der dem wenigstens einen Leuchtmittel abgewandte Seite der Trägerlage angeordnet ist und/oder wobei bevorzugt die Trägerlage zumindest ein elektrisches Kontaktelement umfasst, welches die Leiterbahnschicht elektrisch kontaktiert und welches von einer Außenseite des Mehrschichtkörpers elektrisch kontaktierbar ist, insbesondere eine Durchkontaktierung durch die Trägerlage und/oder ein Krimpelement, und/oder ein Teilbereich der Leiterbahnschicht, der nicht von der Kunststofflage bedeckt ist oder von dem die Kunststofflage reversibel ablösbar ist.

## Claims

1. Method for producing a multilayer body, having the following steps:
a) providing a carrier ply on which at least one LED is arranged;
b) providing a decorative ply;
c) overmoulding a plastic ply onto the carrier ply and/or the decorative ply in an injection moulding tool;
and that a conductor track layer for contacting the at least one illuminant is applied to the carrier ply, wherein the conductor track layer is generated by vapour deposition, sputtering, galvanic deposition or lamination of a metal and/or by applying conductive pigments, nanoparticles, ITO, ATO, conductive organic polymers, carbon nanotubes, graphene or carbon black with a layer thickness from 10nm to 50µm,
and wherein the conductor track layer comprises at least one coupling surface, wherein, seen perpendicularly to the carrier ply, a complementary coupling surface is applied to the side of the carrier ply facing away from the at least one illuminant,
and/or wherein the conductor track layer comprises at least one coil and/or antenna structure, wherein, seen perpendicularly to the carrier ply, a complementary coil and/or antenna structure is applied to the side of the carrier ply facing away from the at least one illuminant,
and/or wherein at least one electric contact element is applied to the carrier ply, said contact element electrically contacting the conductor track layer and being at most partially enclosed by the plastic mass when injection moulding the plastic ply, and/or wherein at least one partial region of the conductor track layer is not enclosed by the plastic mass when injection moulding the plastic ply and/or a partial region of the carrier ply, on which at least one partial region of the conductor track layer is arranged, is detached from the plastic ply after injection moulding the plastic ply, and at least one optical auxiliary layer is applied to the decorative ply and/or the carrier ply and/or the overmoulded plastic ply,
and recesses are provided in the decorative ply, which also penetrate the optical auxiliary layer.

2. Method according to claim 1,
**characterised in that**
the decorative ply is applied to the carrier ply, wherein the decorative ply is preferably applied to the side of the carrier layer facing away from the at least one illuminant or to the side of the carrier ply facing towards the at least one illuminant, in particular between the illuminant and the carrier ply, and/or wherein the decorative ply and the carrier ply are preferably fixed in a half-mould of the injection moulding tool, in particular using mechanical clamping means and/or a vacuum, and are back-moulded on one side.

3. Method according to claim 1,
**characterised in that**
the plastic ply is overmoulded between the side of the carrier ply facing away from the at least one illuminant and the decorative ply or between the side of the carrier ply facing towards the at least one illuminant and the decorative ply, wherein the decorative ply is preferably fixed in a first half-mould of the injection moulding tool and the carrier ply in a second half-mould of the injection moulding tool, in particular using mechanical clamping means and/or a vacuum.

4. Method according to one of claims 1 to 3,
**characterised in that**
the carrier ply is provided as a circuit board, in particular made of FR4, polyimide or paper, with a layer thickness of from 50µm to 2mm, preferably from 100µm to 1.5mm.

5. Method according to one of claims 1 to 4,
**characterised in that**
SMD-LEDs with a length of from 400µm to 20mm, preferably from 0.6mm to 2mm, a width of from 200µm to 5mm, preferably from 0.3mm to 1.25mm, and a height of from 200µm to 5mm, preferably from 0.2mm to 1.5mm, and/or chip-LEDs with a length of from 100µm to 2mm, preferably from 0.2mm to 0.5mm, a width of from 100µm to 2mm, preferably from 0.2mm to 0.5mm, and a height of from 50µm to 250µm, preferably from 75µm to 125µm are used as the illuminant.

6. Method according to one of claims 1 to 5,
**characterised in that**
at least one optical auxiliary layer, in particular a reflection layer or absorption layer, is applied to the decorative ply and/or the carrier ply and/or the overmoulded plastic ply, wherein the at least one optical auxiliary layer is generated by vapour deposition or sputtering of a metal, in particular aluminium, silver, chromium, copper, gold or alloys thereof, with a layer thickness of from 1nm to 500nm, preferably from 5nm to 100nm, or is generated by printing lacquers containing metal pigments with a layer thickness of from 0.1 µm to 50µm, preferably from 1µm to 20µm, and/or wherein the at least one optical auxiliary layer is generated by applying a pigmented lacquer, in particular comprising carbon black pigments, with a layer thickness of from 0.1µm to 50µm, preferably from 1µm to 20µm.

7. Method according to one of claims 1 to 6,
**characterised in that**
the decorative ply provided comprises at least one first region, which is at least partially transparent with respect to the spectrum of the light emitted by the at least one illuminant, and at least one second region, which is non-transparent with respect to the spectrum of the light emitted by the at least one illuminant, wherein the decorative ply is preferably arranged in such a way that, seen perpendicularly to the surface of the decorative ply, the at least one illuminant is superimposed by the at least one first region, and/or wherein the decorative ply is preferably arranged in such a way that, seen perpendicularly to the surface of the decorative ply, the at least one illuminant is superimposed by the at least one second region.

8. Method according to one of claims 1 to 7,
**characterised in that**
colourants, in particular dyes and/or pigments and/or particles and/or quantum dot materials, are added to the plastic material used for injection moulding the plastic ply and/or to a material forming a layer of the carrier ply, said colourants absorbing and/or scattering in the wavelength range of the light emitted by the at least one illuminant and/or being able to be encouraged to fluoresce or phosphoresce in the visible wavelength range, wherein the added colourants, in particular, comprise inorganic pigments and/or particles, in particular made of silicon dioxide, pyrogenic silicic acid, titanium dioxide, zinc sulphide and/or a metal, with a particle size of from 5nm to 500µm, preferably from 500nm to 100µm.

9. Method according to one of claims 1 to 8,
**characterised in that**
a decorative ply is provided, which has a plurality of regions that differ in terms of colour and/or transparency with respect to the spectrum of the light emitted by the at least one illuminant, and/or a partial layer, in particular a metal layer, which is non-transparent with respect to the spectrum of the light emitted by the at least one illuminant, is applied to the decorative ply, said layer comprising a piece of optical information.

10. Method according to one of claims 1 to 9,
**characterised in that**
an optically active relief structure, in particular a diffractive structure, a zeroth-order diffraction structure, a macrostructure, a lens structure, a microlens structure, a microprism structure, is introduced into the decorative ply and/or the carrier ply and/or the plastic ply, in particular by replication and/or by casting a die arranged in the injection moulding tool, and/or at least two plastic masses are used when injection moulding the plastic ply, which differ in terms of one optical property, in particular in terms of their refraction index.

11. Method according to one of claims 1 to 10,
**characterised in that**
a conductor track layer for contacting the at least one illuminant is applied to the carrier ply, wherein the conductor track layer is generated by vapour deposition, sputtering, galvanic deposition or laminating of aluminium, silver, chromium, copper, gold or alloys thereof, and/or by applying PEDOT or PANI with a layer thickness of from 10nm to 50µm.

12. Multilayer body, produced by means of a method according to one of claims 1 to 11, having a carrier ply, on which at least one LED is arranged, a decorative ply and an overmoulded plastic ply, in particular made of PMMA, ABS, PS, PE, PP, PC, POM, PA, ASA, SAN or TPU, wherein the decorative ply is preferably arranged on the side of the carrier ply facing away from or towards the at least one illuminant, or wherein the plastic ply is preferably arranged between the side of the carrier ply facing away from or towards the at least one illuminant and the decorative ply.

13. Multilayer body according to claim 12,
**characterised in that**
at least one optical auxiliary layer, in particular a reflection layer made of a metal, in particular aluminium, silver, chromium, copper, gold or alloys thereof, with a layer thickness of from 10m to 500nm, preferably from 5nm to 100nm, or an absorption layer, made of a pigmented lacquer, in particular comprising carbon black pigments, with a layer thickness of from 0.1µm to 50µm, preferably from 1µm to 20µm, is arranged on the decorative ply and/or the carrier ply and/or the overmoulded plastic ply.

14. Multilayer body according to one of claims 12 or 13,
**characterised in that**
the decorative ply comprises at least one first region, which is at least partially transparent with respect to the spectrum of the light emitted by the at least one illuminant, and at least one second region, which is non-transparent with respect to the spectrum of the light emitted by the at least one illuminant, wherein the decorative ply is arranged in such a way that, seen perpendicularly to the surface of the decorative ply, the at least one illuminant is superimposed by the at least one first region and/or by the at least one second region, and/or the decorative ply has a plurality of regions that differ in terms of colour and/or transparency with respect to the spectrum of the light emitted by the at least one illuminant, and/or the decorative ply and/or the carrier ply and/or the plastic ply comprises a diffractive grating structure.

15. Multilayer body according to one of claims 12 to 14,
**characterised in that**
the carrier ply comprises a conductor track layer for contacting the at least one illuminant, which is formed in particular from a metal, in particular aluminium, silver, chromium, copper, gold or alloys thereof, and/or from conductive pigments, nanoparticles, ITO, ATO, conductive organic polymers, in particular PEDOT or PANI, carbon nanotubes, graphene or carbon black with a layer thickness of from 1nm to 500µm, preferably from 10nm to 50µm, wherein the conductor track layer preferably comprises at least one electric contact element, in particular a coupling surface and/or coil structure and/or antenna structure, which is arranged on the side of the carrier ply facing away from the at least one illuminant in superimposition with a complementary coupling surface and/or coil structure and/or antenna structure, and/or wherein the carrier ply preferably comprises at least one electric contact element, which electrically contacts the conductor track layer and which can be electrically contacted by an outer side of the multilayer body, in particular a through-contacting by the carrier ply and/or a crimping element, and/or a partial region of the conductor track layer, which is not covered by the plastic ply or from which the plastic ply can be reversibly detached.

## Revendications

1. Procédé de fabrication d'un corps multicouche, avec les étapes de :
a) mise à disposition d'une couche support, sur laquelle au moins une DEL est agencée ;
b) mise à disposition d'une couche décorative ;
c) moulage par injection d'une couche plastique sur la couche support et/ou la couche décorative dans un outil de moulage par injection ;
et qu'une couche de pistes conductrices est appliquée sur la couche support pour le contact de l'au moins un moyen d'éclairage, dans lequel la couche de pistes conductrices est générée par dépôt par évaporation, pulvérisation, dépôt galvanique ou stratification d'un métal et/ou application de pigments conducteurs, nanoparticules, ITO, ATO, polymères organiques conducteurs, nanotubes de carbone, graphes ou suie avec une épaisseur de couche de 10 nm à 50 µm
et dans lequel la couche de pistes conductrices comprend au moins une surface de couplage, dans lequel une couche de couplage complémentaire est appliquée, vu perpendiculairement à la couche support, sur le côté de la couche support opposé à l'au moins un moyen d'éclairage,
et/ou dans lequel la couche de pistes conductrices comprend au moins une structure de bobine et/ou d'antenne, dans lequel une structure de bobine et/ou d'antenne complémentaire est appliquée, vu perpendiculairement à la couche support, sur le côté de la couche support opposé à l'au moins un moyen d'éclairage,
et/ou dans lequel au moins un élément de contact électrique est appliqué sur la couche support, lequel est en contact électrique avec la couche de pistes conductrices et lequel est enfermé lors du moulage par injection de la couche plastique au maximum en partie par la masse de matière plastique
et/ou dans lequel lors du moulage par injection de la couche plastique, au moins une zone partielle de la couche de pistes conductrices n'est pas enfermée par la masse de matière plastique et/ou après le moulage par injection de la couche plastique, une zone partielle de la couche support, sur laquelle au moins une zone partielle de la couche de pistes conductrices est agencée, est détachée de la couche plastique
et qu'au moins une couche auxiliaire optique est appliquée sur la couche décorative et/ou la couche support et/ou la couche plastique moulée par injection
et que des évidements sont prévus dans la couche décorative, qui traversent également la couche auxiliaire optique.

2. Procédé selon la revendication 1,
**caractérisé en ce**
**que** la couche décorative est appliquée sur la couche support, dans lequel de préférence la couche décorative est appliquée sur le côté de la couche support opposé à l'au moins un moyen d'éclairage ou sur le côté de la couche support tourné vers l'au moins un moyen d'éclairage, en particulier entre le moyen d'éclairage et la couche support, et/ou dans lequel de préférence la couche décorative et la couche support sont fixées dans une moitié de moule de l'outil de moulage par injection, en particulier par moyens de serrage mécaniques et/ou sous vide, et surmoulées d'un côté.

3. Procédé selon la revendication 1,
**caractérisé en ce**
**que** la couche plastique est moulée par injection entre le côté de la couche support opposé à l'au moins un moyen d'éclairage et la couche décorative ou entre le côté de la couche support tourné vers l' au moins un moyen d'éclairage et la couche décorative, dans lequel de préférence la couche décorative est fixée dans une première moitié de moule de l'outil de moulage par injection et la couche support est fixée dans une seconde moitié de moule de l'outil de moulage par injection, en particulier par moyens de serrage mécaniques et/ou sous vide.

4. Procédé selon l'une quelconque des revendications 1 à 3,
**caractérisé en ce**
**que** la couche support est mise à disposition en tant que carte de circuit imprimé, en particulier en FR4, polyimide ou papier, avec une épaisseur de couche de 50 µm à 2 mm, de préférence de 100 µm à 1,5 mm.

5. Procédé selon l'une quelconque des revendications 1 à 4,
**caractérisé en ce**
**que** des DEL SMD avec une longueur de 400 µm à 20 mm, de préférence de 0,6 mm à 2 mm, une largeur de 200 µm à 5 mm, de préférence de 0,3 mm à 1,25 mm, et une hauteur de 200 µm à 5 mm, de préférence de 0,2 mm à 1,5 mm, et/ou des DEL de puce avec une longueur de 100 µm à 2 mm, de préférence de 0,2 mm à 0,5 mm, une largeur de 100 µm à 2 mm, de préférence de 0,2 mm à 0,5 mm, et une hauteur de 50 µm à 250 µm, de préférence de 75 µm à 125 µm sont utilisées en tant que moyens d'éclairage.

6. Procédé selon l'une quelconque des revendications 1 à 5,
**caractérisé en ce**
**qu'**au moins une couche auxiliaire optique, en particulier une couche de réflexion ou couche d'absorption, est appliquée sur la couche décorative et/ou la couche support et/ou la couche plastique moulée par injection, dans lequel l'au moins une couche auxiliaire optique est générée par dépôt par évaporation ou pulvérisation d'un métal, en particulier aluminium, argent, chrome, cuivre, or ou des alliages de ceux-ci, avec une épaisseur de couche de 1 nm à 500 nm, de préférence de 5 nm à 100 nm, ou par impression de vernis contenant des pigments métalliques avec une épaisseur de couche de 0,1 µm à 50 µm, de préférence de 1 µm à 20 µm, et/ou dans lequel l'au moins une couche auxiliaire optique est générée par application d'un vernis pigmenté, comprenant en particulier des pigments de suie, avec une épaisseur de couche de 0,1 µm à 50 µm, de préférence de 1 µm à 20 µm.

7. Procédé selon l'une quelconque des revendications 1 à 6,
**caractérisé en ce**
**que** la couche décorative mise à disposition comprend au moins une première zone, laquelle est au moins partiellement transparente par rapport au spectre de la lumière émise par l'au moins un moyen d'éclairage, et au moins une seconde zone, laquelle est opaque par rapport au spectre de la lumière émise par l'au moins un moyen d'éclairage, dans lequel de préférence la couche décorative est agencée de sorte que l'au moins un moyen d'éclairage vient recouvrir, vu perpendiculairement à la surface de la couche décorative, l'au moins une première zone, et/ou dans lequel de préférence la couche décorative est agencée de sorte que l'au moins un moyen d'éclairage vient recouvrir, vu perpendiculairement à la surface de la couche décorative, l'au moins une seconde zone.

8. Procédé selon l'une quelconque des revendications 1 à 7,
**caractérisé en ce**
**que** des colorants, en particulier des substances colorantes et/ou des pigments et/ou des particules et/ou des matériaux de points quantiques, sont ajoutés au matériau plastique utilisé pour le moulage par injection de la couche plastique et/ou à un matériau formant une couche de la couche support, lesquels absorbent ou diffusent dans la plage de longueur d'onde de la lumière émise par l'au moins un moyen d'éclairage et/ou peuvent être stimulés pour la fluorescence ou phosphorescence dans la plage de longueur d'onde visible, dans lequel en particulier les colorants ajoutés comprennent des particules et/ou des pigments anorganiques, en particulier en dioxyde de silicium, silice pyrogénée, dioxyde de titane, sulfure de zinc ou un métal, avec une taille de particule de 5 nm à 500 µm, de préférence de 500 nm à 100 µm.

9. Procédé selon l'une quelconque des revendications 1 à 8,
**caractérisé en ce**
**qu'**une couche décorative est mise à disposition, laquelle présente une pluralité de zones, qui se distinguent en couleur et/ou transparence par rapport au spectre de la lumière émise par l'au moins un moyen d'éclairage et/ou qu'une couche partielle opaque par rapport au spectre de la lumière émise par l'au moins un moyen d'éclairage, en particulier une couche métallique, laquelle comprend une information optique, est appliquée sur la couche décorative.

10. Procédé selon l'une quelconque des revendications 1 à 9,
**caractérisé en ce**
**qu'**une structure en relief optiquement active, en particulier une structure diffractive, une structure de diffraction d'ordre zéro, une macrostructure, une structure de lentille, une structure de microlentille, une structure de micro-prisme, est introduite dans la couche décorative et/ou la couche support et/ou la couche plastique, en particulier par réplication et/ou par moulage d'une matrice agencée dans l'outil de moulage par injection et/ou que lors du moulage par injection de la couche plastique au moins deux masses de matière plastique sont utilisées, qui se distinguent par une propriété optique, en particulier par leur indice de réfraction.

11. Procédé selon l'une quelconque des revendications 1 à 10,
**caractérisé en ce**
**qu'**une couche de pistes conductrices est appliquée sur la couche support pour le contact de l'au moins un moyen d'éclairage, dans lequel la couche de pistes conductrices est générée par dépôt par évaporation, pulvérisation, dépôt galvanique ou stratification d'aluminium, d'argent, de chrome, de cuivre, d'or ou d'alliages de ceux-ci, et/ou par application de PEDOT ou PANI avec une épaisseur de couche de 10 nm à 50 µm.

12. Corps multicouche, fabriqué au moyen d'un procédé selon l'une quelconque des revendications 1 à 11, avec une couche support, sur laquelle l'au moins une DEL est agencée, une couche décorative et une couche plastique moulée par injection, en particulier en PMMA, ABS, PS, PE, PP, PC, POM, PA, ASA, SAN ou TPU, dans lequel la couche décorative est agencée de préférence sur le côté de la couche support opposé à ou tourné vers l'au moins un moyen d'éclairage, ou dans lequel de préférence la couche plastique est agencée entre le côté de la couche support opposé à ou tourné vers l'au moins un moyen d'éclairage et la couche décorative.

13. Corps multicouche selon la revendication 12,
**caractérisé en ce**
**qu'**au moins une couche auxiliaire optique, en particulier une couche de réflexion en un métal, en particulier aluminium, argent, chrome, cuivre, or, ou des alliages de ceux-ci, avec une épaisseur de couche de 1 nm à 500 nm, de préférence de 5 nm à 100 nm, ou une couche d'absorption en un vernis pigmenté, comprenant en particulier des pigments de suie, avec une épaisseur de couche de 0,1 µm à 50 µm, de préférence de 1 µm à 20 µm, est appliquée sur la couche décorative et/ou la couche support et/ou la couche plastique moulée par injection.

14. Corps multicouche selon l'une quelconque des revendications 12 ou 13,
**caractérisé en ce**
**que** la couche décorative comprend au moins une première zone, laquelle est au moins partiellement transparente par rapport au spectre de la lumière émise par l'au moins un moyen d'éclairage, et au moins une seconde zone, laquelle est opaque par rapport au spectre de la lumière émise par l'au moins un moyen d'éclairage, dans lequel la couche décorative est agencée de sorte que l'au moins un moyen d'éclairage vient recouvrir, vu perpendiculairement à la surface de la couche décorative, l'au moins une première zone et/ou l'au moins une seconde zone et/ou la couche décorative présente une pluralité de zones, qui se distinguent en couleur et/ou transparence par rapport au spectre de la lumière émise par l'au moins un moyen d'éclairage et/ou la couche décorative et/ou la couche support et/ou la couche plastique comprend une structure de réseau diffractive.

15. Corps multicouche selon l'une quelconque des revendications 12 à 14,
**caractérisé en ce**
**que** la couche support une couche de pistes conductrices pour le contact de l'au moins un moyen d'éclairage, laquelle est réalisée en particulier en un métal, en particulier aluminium, argent, chrome, cuivre, or ou des alliages de ceux-ci, et/ou en pigments conducteurs, nanoparticules, ITO, ATO, polymères organiques conducteurs, en particulier PEDOT ou PANI, nanotubes de carbone, graphes ou suie avec une épaisseur de couche de 1 nm à 500 µm, de préférence 10 nm à 50 µm, dans lequel de préférence la couche de pistes conductrices comprend au moins un élément de contact électrique, en particulier une surface de couplage et/ou structure de bobine et/ou structure d'antenne, qui est agencé sur le côté de la couche support opposé à l'au moins un moyen d'éclairage, en recouvrement par rapport à une surface de couplage et/ou structure de bobine et/ou structure d'antenne complémentaire et/ou dans lequel de préférence la couche support comprend au moins un élément de contact électrique, lequel est en contact électrique avec la couche de pistes conductrices et lequel peut être en contact électrique par un côté extérieur du corps multicouche, en particulier un contact traversant la couche support et/ou un élément serti, et/ou une zone partielle de la couche de pistes conductrices, qui n'est pas recouverte par la couche plastique ou duquel la couche plastique peut être détachée de manière réversible.
